# EUROPEAN PATENT APPLICATION

(11) **EP 4 672 208 A1**
(43) Date of publication of application: **31.12.2025**
(21) Application number: 25185039.2
(22) Date of filing: 24.06.2025
(51) Int. Cl.: G09G 3/20, G09G 3/3266, G09G 3/36

(54) **GATE CIRCUIT FOR DRIVING FOVEATED DISPLAYS**

(30) Priority: 27.06.2024 US 202463665027 P; 18.06.2025 US 202519242187
(71) Applicant: Meta Platforms Technologies, LLC, Menlo Park, CA 94025 (US)
(72) Inventor: In, Hai Jung, Menlo Park (US); Kitsomboonloha, Rungrot, Menlo Park (US); Martinez, Misael Perez, Menlo Park (US); Choi, Min Hyuk, Menlo Park (US); Sivakumar, Balasubramanian, Menlo Park (US)
(74) Representative: Murgitroyd & Company

(57) **Abstract**

A gate circuit is described comprising flip flops that are each driven by one of two clock signals, and which are arranged such that adjusting the frequency of one of these clock signals changes the number of subsets of display elements that are simultaneously driven. In a foveated display, an image may be produced with different effective resolutions in different parts of the same image by treating groups of display elements as a single pixel. For example, a more detailed portion of the image may be produced with each display element having an independent color, whereas a less detailed portion of the same image may be produced with multiple contiguous display elements having the same color. The gate circuit described herein may allow multiple rows to be activated to produce output from at least some of their display elements at the same time as one another.

## Description

### TECHNICAL FIELD

The present disclosure is generally directed to techniques for driving a foveated display.

### BACKGROUND

Foveated imaging is a display technique in which the image resolution can vary across a single image. For instance, a portion of an image corresponding to the center of the eye's retina (the fovea) may be rendered at a higher resolution than portions of the image far from the eye's retina. The regions of the image rendered with a lower resolution may not be noticeable due to the reduced contrast sensitivity of the eye at its periphery compared to its center.

### SUMMARY

According to a first aspect, there is provided a system comprising: a plurality of addressable display elements comprising a plurality of subsets; a shift register comprising a first plurality of flip flops each coupled to a first clock input; a second plurality of flip flops each configured to receive an output from a respective one of the first plurality of flip flops, each of the second plurality of flip flops being coupled to a second clock input, and each of the second plurality of flip flops configured to output a gate signal to a respective subset of the plurality of subsets of the plurality of addressable display elements; and a controller configured to control, by controlling a frequency of the first clock input, which one or more subsets of the plurality of addressable display elements simultaneously receive the gate signal from flip flops of the second plurality of flip flops.

The plurality of addressable display elements may be arranged in a plurality of rows and a plurality of columns.

The plurality of addressable display elements may be arranged in a grid. The plurality of subsets of the plurality of addressable display elements may be rows of addressable display elements in the grid.

The plurality of subsets of the plurality of addressable display elements may be a plurality of first subsets of the plurality of addressable display elements. The controller may be further configured to send a display signal to selected ones of a plurality of second subsets of the plurality of addressable display elements. Each of the plurality of second subsets may intersect each of the plurality of first subsets.

The plurality of addressable display elements may be arranged in a grid. The plurality of first subsets may be a plurality of rows of addressable display elements in the grid. The plurality of second subsets may be a plurality of columns of the addressable display elements in the grid.

The display signal may control a brightness and/or color of light to be emitted by display elements in the plurality of second subsets of the plurality of addressable display elements that also receive the gate signal from one or more flip flops of the second plurality of flip flops.

The frequency of the first clock input may be an integer multiple of a frequency of the second clock input.

At least some of the first plurality of flip flops in the shift register may be configured to receive an input from the output of another of the first plurality of flip flops.

A first flip flop in the first plurality of flip flops in the shift register may be configured to receive an input pattern signal. Each of the first plurality of flip flops other than the first flip flop may be configured to receive an input from the output of another of the first plurality of flip flops.

The controller may be configured to adjust the frequency of the first clock input while the plurality of addressable display elements are operated to produce an image frame by successively providing the gate signal to each of the plurality of subsets of the plurality of addressable display elements.

The controller, the shift register and the second plurality of flip flops may be implemented as an integrated circuit.

According to a second aspect, there is provided a method comprising: providing an input pattern to a shift register comprising a first plurality of flip flops each operating according to a first clock frequency; producing first gate signals from a first subset of a second plurality of flip flops each configured to receive an output from a respective one of the first plurality of flip flops; directing each of the first gate signals to respective rows of display elements in a grid of display elements; increasing or decreasing the first clock frequency; and producing second gate signals from a second subset of the second plurality of flip flops, wherein a number of the second plurality of flip flops in the first subset is different from a number of the second plurality of flip flops in the second subset.

The method may further comprise directing each of the second gate signals to respective rows of the display elements in the grid of display elements.

The method may further comprise: producing a respective first gate signal from each of two of the second plurality of flip flops; decreasing the first clock frequency by a factor of two; and producing a single second gate signal from one of the second plurality of flip flops.

The method may further comprise directing a display signal to one or more columns of display elements in the grid of display elements, thereby simultaneously directing both the display signal and one or more of the first gate signals to one or more display elements.

The method may further comprise directing the display signal to two columns of display elements in the grid of display elements and simultaneously directing a respective gate signal of the first gate signals to two rows of display elements, thereby simultaneously directing both the display signal and one of the first gate signals to four display elements.

Increasing or decreasing the first clock frequency may comprise decreasing the first clock frequency by a factor of two. The display signal may be a first display signal. The method may comprise, subsequent to simultaneously directing both the first display signal and one of the first gate signals to four display elements, directing a second display signal to a single column of display elements in the grid of display elements and simultaneously directing a single second gate signal to a single row of display elements.

The method may further comprise increasing or decreasing the first clock frequency while producing an image frame from the grid of display elements by successively providing gate signals of the first gate signals to each of the rows of display elements.

The second plurality of flip flops may each operate according to a second clock frequency.

The first clock frequency may be an integer multiple of the second clock frequency.

### BRIEF DESCRIPTION OF THE DRAWINGS

The accompanying drawings illustrate a number of examples and are a part of the specification. Together with the following description, these drawings demonstrate and explain various principles of the present disclosure.
FIG. 1 depicts an illustrative foveated display.
FIG. 2 depicts addressing of display elements in a display.
FIG. 3 depicts an illustrative gate circuit.
FIGs. 4 and 5 depict example of signals at various points within the illustrative gate circuit of FIG. 3.
FIG. 6 depicts an illustrative system that may be operated accordingly to the techniques described herein.
FIG. 7 is a flow diagram of an exemplary method for computer-implemented method 700 for rendering an image frame in a foveated display.
FIG. 8 is an illustration of an example artificial-reality system.
FIG. 9 is an illustration of an example artificial-reality system with a handheld device.
FIG. 10A is an illustration of example user interactions within an artificial-reality system.
FIG. 10B is an illustration of example user interactions within an artificial-reality system.
FIG. 11A is an illustration of example user interactions within an artificial-reality system.
FIG. 11B is an illustration of example user interactions within an artificial-reality system.
FIG. 12 is an illustration of an example wrist-wearable device of an artificial-reality system.
FIG. 13 is an illustration of an example wearable artificial-reality system.
FIG. 14 is an illustration of an example augmented-reality system.
FIG. 15A is an illustration of an example virtual-reality system.
FIG. 15B is an illustration of another perspective of the virtual-reality systems shown in FIG. 15A.
FIG. 16 is a block diagram showing system components of example artificial- and virtual-reality systems.
FIG. 17 is an illustration of an example system that incorporates an eye-tracking subsystem capable of tracking a user's eye(s).
FIG. 18 is a more detailed illustration of various aspects of the eye-tracking subsystem illustrated in FIG. 17.

Throughout the drawings, identical reference characters and descriptions indicate similar, but not necessarily identical, elements. While the examples described herein are susceptible to various modifications and alternative forms, specific examples have been shown by way of example in the drawings and will be described in detail herein. However, the examples described herein are not intended to be limited to the particular forms disclosed. Rather, the present disclosure covers all modifications, equivalents, and alternatives falling within the scope of the appended claims.

### DETAILED DESCRIPTION

As will be explained in greater detail below, examples of the present disclosure may include a gate circuit that generates driving signals to address display elements in the foveated display. Typically, a foveated display may be driven to activate successive subsets of the display elements in a display. For instance, a foveated display may drive each row of an array of pixels, with each row of pixels being independantly activated. This approach may, however, require many control signals to drive subsets of the display elements, leading to a complex and potentially unreliable circuit for displays with a large number of display elements. For instance, some displays are driven by clock modules that each may be operated to drive rows rows of the display, where each module is driven by a clock signal that activates the module and also utilizes multiple clock signals to drive each of the rows connected to the module. This approach can require hundreds of clock signals for large displays.

Examples of the present disclosure may provide a gate circuit comprising flip flops that are each driven by one of two clock signals, and which are arranged such that adjusting the frequency of one of these clock signals changes the number of subsets of display elements that are simultaneously driven. For instance, if the display elements are arranged in rows (e.g., in a grid), multiple rows may be simultaneously activated. In a foveated display an image may be produced with different effective resolutions in different parts of the same image by treating groups of display elements as a single pixel. For example, a more detailed portion of the image may be produced where every display element is independently controlled, whereas a less detailed portion of the same image may be produced with multiple contiguous display elements being controlled together to produce the same brightness and/or color. The gate circuit described herein may allow multiple rows of display elements to be activated simultaneously to produce output from at least some of their display elements at the same time as one another. Moreover, this process can be performed dynamically so that the groups of rows that are activated to produce a given image frame can differ from frame to frame. This approach differs from a typical display that addresses rows (or some other subset of display elements) one by one in the same sequence in every image frame.

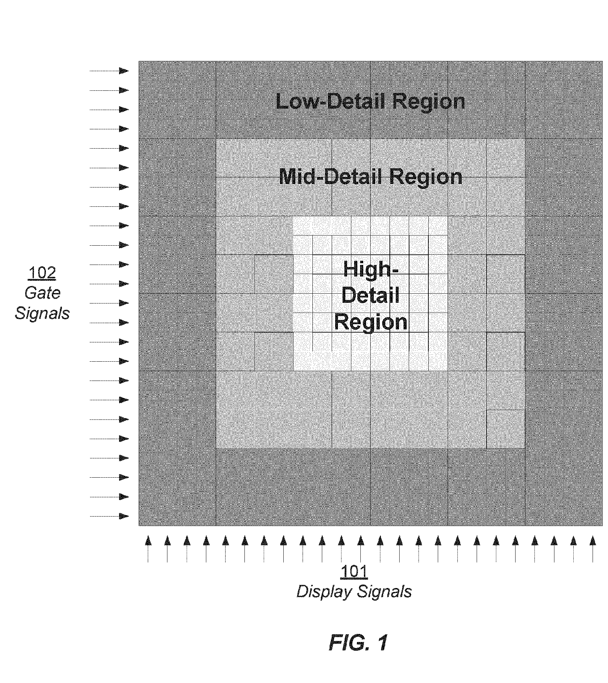

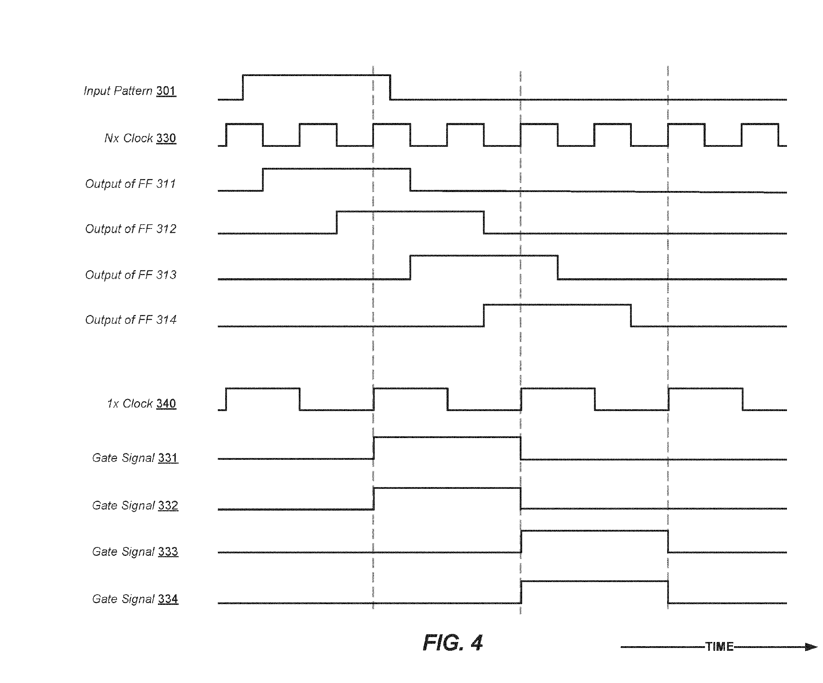

By way of further explanation, FIG. 1 depicts an illustrative foveated display comprising a grid of 576 (24 × 24) display elements (e.g., pixels and/or sub-pixels), according to some examples of the present disclosure. In the example of FIG. 1, an image is generated using a foveation pattern comprising a central high-detail region in which each of the 64 display elements in this region independently produce light of a desired color and/or brightness. In this foveation pattern, a mid-detail region surrounds the high-detail region, and a low-detail region surrounds the mid-detail region. In the mid-detail region, groups of 4 display elements (in a 2×2 block) are operated to produce the same output. That is, in principal any of the display elements in the high-detail region may appear different from one another when the display is operated to produce an image using the depicted foveation pattern, whereas in the mid-detail region each 2×2 block will appear uniform, effectively acting as a larger display element. Similarly, in the low-detail region in FIG. 1, 4×4 blocks of display elements are operated to produce the same output, effectively acting as a single display element that is even larger than those in the mid-detail region.

It will be appreciated that in general the high-detail region may be arranged in different positions in the display from image frame to image frame, and FIG. 1 is merely an illustrative example of a foveation pattern where the high-detail region happens to be in the center. Moreover, any number of contiguous display elements arranged in any suitable size and shape may be operated to produce the same output in any given region. For instance, blocks of 3×3 display elements or 5×5 display elements may be operated in such a manner in a given region of the image. Similarly, any number of regions with different levels of detail may be generated in a given image, and the techniques described herein are not limited to the three regions shown in the example of FIG. 1.

In the example of FIG. 1, a display element in the display is addressed when a gate signal 101 and a display signal 102 are both provided to the display element. As shown, the gate signals may be provided along rows of the display, and the display signals provided along columns of the display. An individual display element may thereby be addressed by providing a gate signal to the row in which the display element is located, and by providing a display signal to the column in which the display element is located. According to some examples, each gate signal may be a digital value (e.g., 0 or 1) that indicates whether or not the row is active, and each display signal may be an analog signal indicative of how the display element is to be operated (e.g., indicates a brightness level). In a typical display, an image is produced by sequentially activating the rows of the display via successive gate signals, and while each gate signal activates a given row, display signals are provided along successive columns indicating how each display element is to be operated. In this manner, each display element is operated to produce light (e.g., from top-left to bottom-right, row by row).

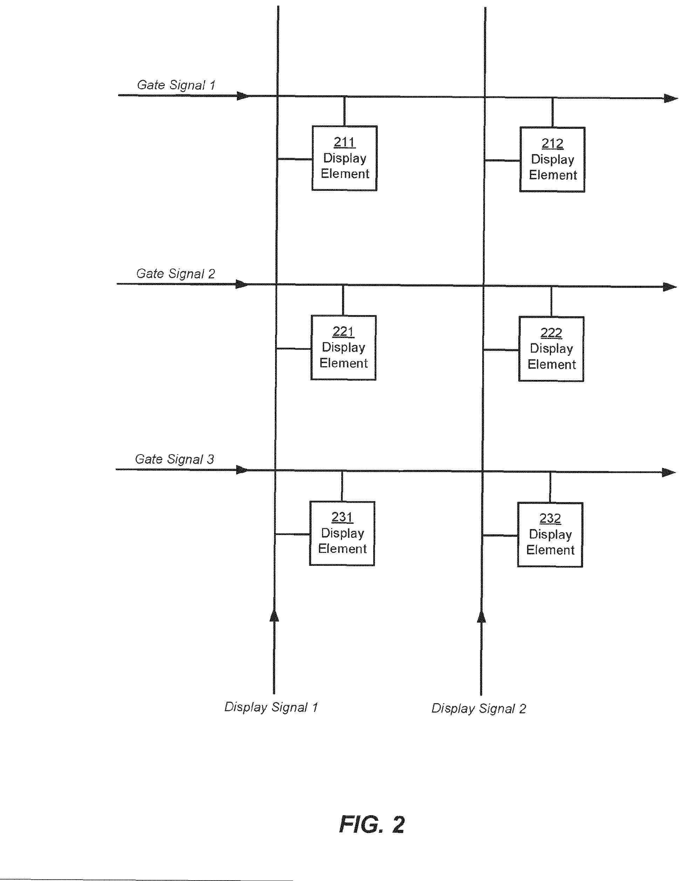

FIG. 2 depicts this type of addressing in more detail, according to some examples of the present disclosure. In the example of FIG. 2, six display elements are depicted, and are arranged in three different rows and two different columns, which may represent part of a larger array of display elements having many rows and columns. Each of the display elements 211, 212, 221, 222, 231 and 232 may be activated by providing both a display signal input and a gate signal input along the columns and rows, respectively, as shown in FIG. 2. For example, display element 211 is activated when gate signal 1 is active and display signal 1 is active, and display element 211 is otherwise not activated. As described above, typically the display elements in a display are activated one by one in succession to produce a single image frame. For example, in the example of FIG. 2, the gate signal 1 may be set active and display signal 1 provided so that display element 211 is operated according to the display signal 1; then the display signal 1 may stop and display signal 2 may be provided, while the gate signal 1 remains active, so that display element 212 is operated according to the display signal 2; and so forth.

Typical display drivers orchestrate this process of addressing row by row by generating successive gate signals for each row. In some arrangements, the gate signals are generated by a circuit that sends an active signal to a desired row by receiving a control input (e.g., clock signal) associated with that row. In other words, a signal path from some controller to the gate signal generator is needed for each of the different gate signals (e.g., per row of the display). There may, however, be an unsatisfactory chance of an error or other unintended result for large displays given the complexity of controlling a large number of rows.

As described above, examples of the present disclosure may provide a gate circuit comprising flip flops that are each driven by one of two clock signals, and which are arranged such that adjusting the frequency of one of these clock signals changes the number of subsets of display elements that are simultaneously driven. This approach to generating gate signals may be simpler and more robust than the approach described above in which a control signal path is needed to turn each of the different gate signals on and off.

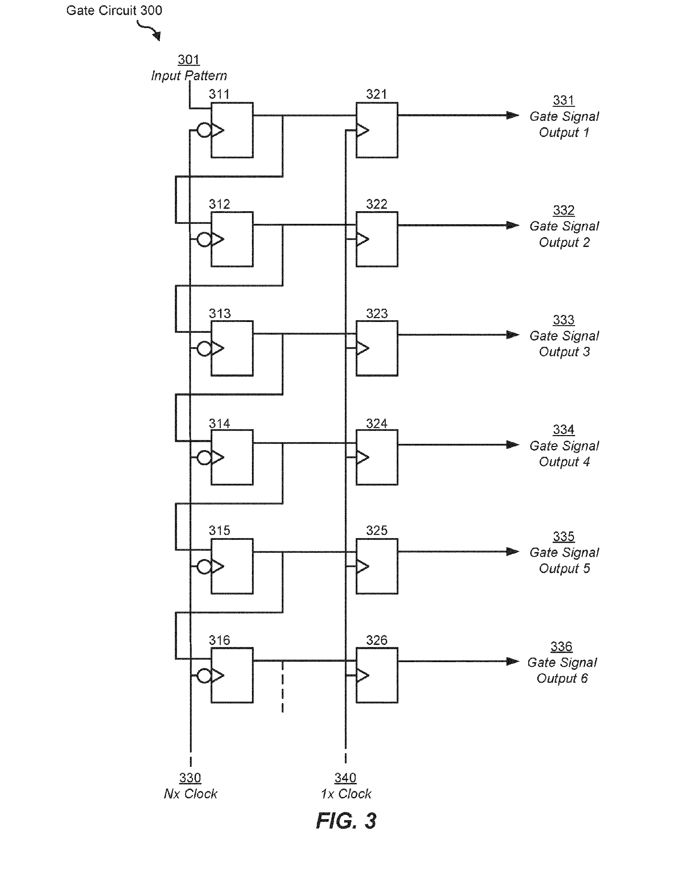

FIG. 3 depicts an illustrative gate circuit, according to some examples of the present disclosure. In the example of FIG. 3, gate circuit 300 comprises a first plurality of flip flops 311, 312, 313, 314, 315 and 316, which are operated as a shift register. An input pattern 301 (e.g., a digital signal comprising a sequence of high and low voltages) is provided as input to the flip flop 311, and this input pattern is shifted down the flip flops of the shift register according to Nx clock signal 330. At a clock edge of the Nx clock signal 330 (e.g., the leading edge or the falling edge), each of flip flops 311, 312, 313, 314, 315 and 316 samples its input and holds it as the output until the next clock edge. Since the output of each of the flip flops 311, 312, 313, 314, 315 and 316 is coupled to the input of the next flip flop in the shift register, this causes the input pattern to shift through the flip flops of the shift register, according to the Nx clock signal 330.

In addition, gate circuit 300 comprises a second plurality of flip flops 321, 322, 323, 324, 325 and 326, each having an input coupled to a respective output of the first plurality of flip flops 311, 312, 313, 314, 315 and 316 (e.g., the output of flip flop 311 is coupled to the input of flip flop 321, etc.). The second plurality of flip flops 321, 322, 323, 324, 325 and 326 are operated according to 1x clock signal 340, and therefore the gate signal outputs 331, 332, 333, 334, 335 and 336 are set active or inactive according to the output of each of the second plurality of flip flops 321, 322, 323, 324, 325 and 326.

As will be described further below, by changing the frequency of the Nx clock signal 330 part way through an image frame, the number of gate signals that are simultaneously active may be controlled. For instance, in the illustrative display of FIG. 1, it may be desirable to simultaneously provide active gate signals to each of the first four rows of display elements. At the same time, a display signal (or multiple instances of the same display signal) may be directed to four columns (e.g., the first four columns) so that sixteen display elements are simultaneously addressed to produce the same output from a 4×4 blocks of display elements. Thus, an image frame may be produced more efficiently than other approaches in which each display element is individually addressed.

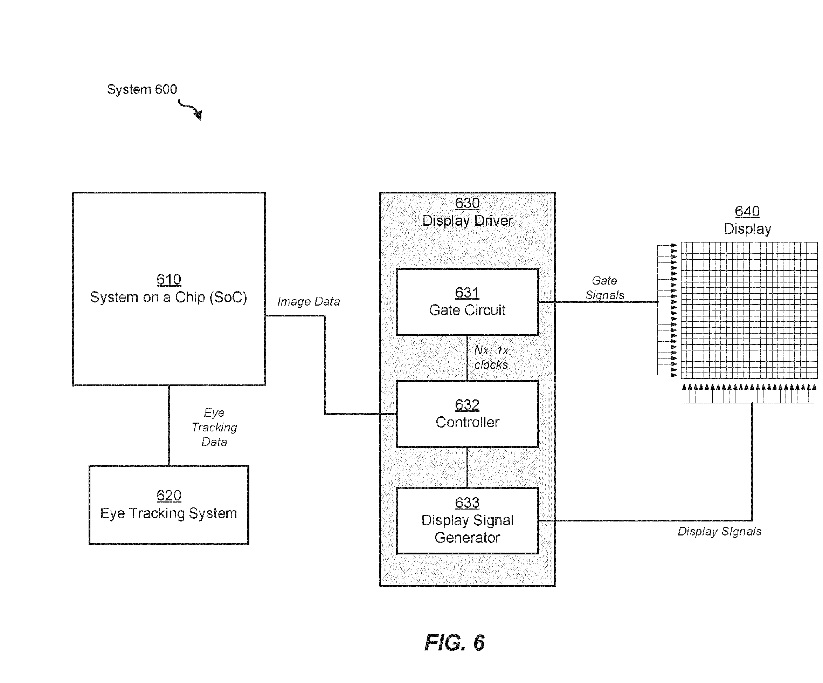

According to some examples, the frequency of the Nx clock signal 330 is an integer multiple of the frequency of the 1x clock signal 340. For instance, the frequency of the Nx clock signal 330 may be equal to (×1) the frequency of the 1x clock signal 340, or may be equal to 2, 3, 4, 5, 6, 7, etc. times the frequency of the 1x clock signal 340. A suitable controller may be configured to produce one or both of the clock signals 330 and 340, and to control the frequency of the clock signal 330 based on data that describes an image to be produced by the display. An example of such a controller is described below in relation to FIG. 6.

In the example of FIG. 3, the flip flops 311, 312, 313, 314, 315 and 316 are configured to be triggered by a negative edge (falling edge), as denoted by the 'bubble' (circle) at the input of each of these flip flops. The depicted circuit need not be configured in this manner in all examples, although there is a benefit to arranging the circuit in this manner to prevent run-on issues between the clock signal 330 and the clock signal 340. This configuration allows the flip flops 311, 312, 313, 314, 315 and 316 to settle to a new value before the flip flops 321, 322, 323, 324, 325 and 326 latch a new input.

FIG. 4 depicts an example of signals at various points within the illustrative gate circuit 300 over time, according to some examples of the present disclosure. In the example of FIG. 4, the digital values of various signals are depicted over time from left to right. As shown, the frequency of the Nx clock 330 is equal to half of the frequency of the 1x clock 340 during the period of time depicted in FIG. 4.

In the example of FIG. 4, a digital input pattern 310 is provided as input to the gate circuit 300, which causes the input pattern to be output from the flip flop 311 at the falling edge of the Nx clock 330, which also sends the input pattern to the input of flip flop 312. In the example of FIG. 4, the ticks of the Nx clock 330 trigger at the falling edge of the Nx clock signal. Subsequently, on the falling edge of the second tick of the Nx clock 330, output of the flip flop 312 is triggered, while the flip flop 311 also outputs a high signal since the input pattern 301 is still being input to the flip flop 311.

In the example of FIG. 4, the clock ticks of the 1x clock 340 are highlighted with vertical dashed lines, which coincide with the falling edge of the 1x clock signal 340. Note that the clock ticks of the 1x clock 340 trigger at the leading edge of the 1x clock signal, in contrast to the clock ticks of the Nx clock which trigger at the falling edge of the Nx clock signal.

As shown in FIG. 4, at the first tick of the 1x clock 340, the outputs of both flip flop 311 and flip flop 312 are high, which causes a high signal to be output from each of flip flops 321 and 322, thereby simultaneously producing active gate signals 331 and 332.

At the third tick of the Nx clock 330, the output of flip flop 311 now becomes low as the input pattern signal is now low, whereas flip flop 312 receives the high signal from flip flop 311 and flip flop 313 receives the high signal from flip flop 312. At the fourth tick of the Nx clock 330, the output of flip flop 312 now becomes low as the output of flip flop 311 is now low, whereas flip flop 313 receives the high signal from flip flop 313 and flip flop 314 receives the high signal from flip flop 313. Subsequently, at the second tick of the 1x clock 340, the outputs of flip flop 313 and 314 are both high, which causes a high signal to be output from each of flip flops 323 and 324, thereby simultaneously producing active gate signals 333 and 334.

A process such as that shown in FIG. 4 may be continued to repeatedly simultaneously produce pairs of gate signals and thereby to simultaneously activate pairs of rows of a display. As described above, however, this behavior may be adjusted at any time, including part way through producing an image frame, by changing the frequency of the Nx clock 330 (e.g., to some other integer multiple of the frequency of the 1x clock 340).

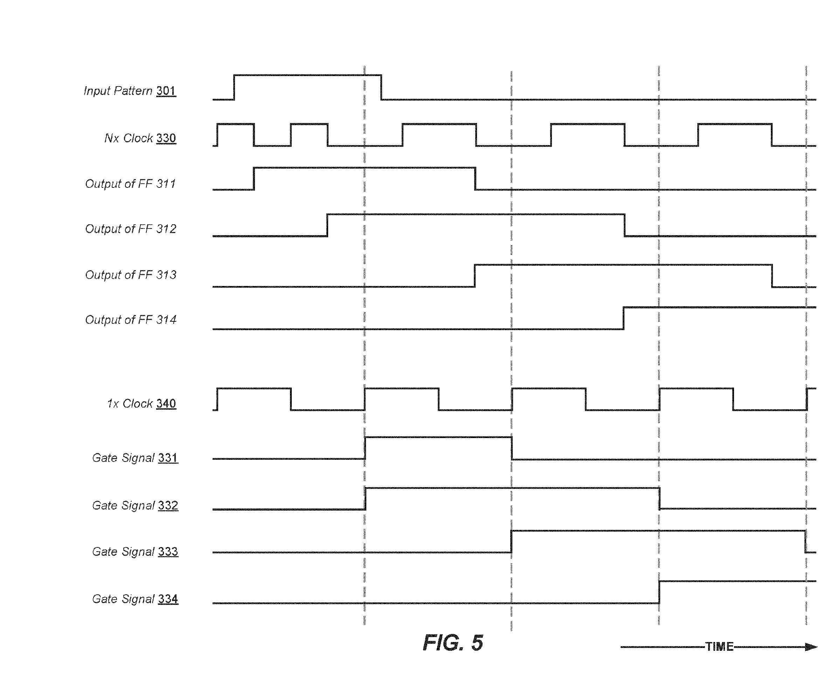

FIG. 5 depicts an example similar to that of FIG. 4 except that, in the example of FIG. 5, after initially producing a gate signal 331 the frequency of the Nx clock 330 is adjusted from twice that of the 1x clock 340 to being equal to the frequency of the 1x clock. In particular, by operating in the same manner as described above in relation to FIG. 4, at the first tick of the 1x clock, the outputs of flip flop 311 and 312 are both high, which causes a high signal to be output from each of flip flops 321 and 322, thereby simultaneously producing active gate signals 331 and 332. Subsequently, the clock frequency of the Nx clock 330 increases to the frequency of the 1x clock 340, and as a result the input pattern signal takes longer to pass through the shift register comprising the flip flops 311, 312, 313, 314, etc. Consequently, at the second tick of the 1x clock, only an active gate signal 333 is triggered. Similarly, at the third tick of the 1x clock, only an active gate signal 334 is triggered.

As such, the number of gates that are simultaneously activated may be controlled during a single image frame numerous times. For instance, for the display shown in FIG. 1, the Nx clock frequency may initially be four times that of the 1x clock frequency so that four rows are simultaneously activated at a time and 4×4 blocks of display elements may be addressed. For rows that contain at least some of the mid-detail region, the Nx clock frequency may then be reduced to twice the 1x clock frequency so that two rows are simultaneously activated at a time and 2×2 blocks of display elements are addressed. For the high-detail region, the Nx clock frequency may then be reduced to the 1x clock frequency so that single rows are activated and single display elements are addressed. Subsequently, the Nx clock frequency may then be increased to twice the 1x clock frequency so that two rows are simultaneously activated at a time and 2×2 blocks of display elements are addressed to produce the lower portion of the mid-detail region, and then the Nx clock frequency may then be increased to four times the 1x clock frequency so that four rows are simultaneously activated at a time and 4×4 blocks of display elements are addressed to produce the lower portion of the low-detail region.

The above is one example, however, and in general the frequency of the Nx clock may be modified a number of times while producing a single image frame, including any one or more increases and/or decreases in frequency, in any suitable order. Moreover, while the size of the mid-detail and low-detail regions in FIG. 1 have a size that is a multiple of two, rendering via the techniques described herein is not limited in this manner. For example, the Nx clock frequency may be adjusted to three times the 1x clock frequency so that three rows are simultaneously activated at a time and 3×3 blocks of display elements are addressed.

FIG. 6 depicts an illustrative system 600 that may be operated accordingly to the techniques described herein, according to some examples of the present disclosure. System 600 may for instance be part of a wearable device, such as an Artificial-Reality system, examples of which are described below.

In the example of FIG. 6, the system 600 is controlled in part by SoC 610, which generates image data for display on display 640. Control of the display 640 is provided by display driver 630, which receives image data from the SoC 610 and generates gate signals and display signals to address display elements in the display as described above. The gate signals are generated in the example of FIG. 6 by gate circuit 631, which may for instance be implemented as gate circuit 300 shown in FIG. 3.

According to some examples, the image data provided by SoC 610 comprises digital values indicating the colors of a plurality of display elements of the display 640. The number of such digital values for a single image frame may be less than the number of display elements in the display since in a foveated display implemented as described herein, display signals may be provided to multiple columns at the same time to address multiple display elements at the same time in conjunction with multiple gate signals. As a result, a data stream representing an image frame may be smaller in size than are necessary when each display element is addressed individually, potentially leading to improved efficiency of display rendering.

In some examples, the image data provided by SoC 610 may also comprise information regarding the foveated layout of the image frame to be rendered, which informs the controller 632 how to operate the gate circuit (e.g., how to control the frequency of the Nx clock of the gate circuit) to render the image frame by, at least in part, activating multiple rows of the display 640 at the same time by simultaneously providing multiple gate signals to display elements of the display. In some examples, information regarding the foveated layout of the image frame to be rendered may comprise the coordinate position in the image frame of various locations in the foveated layout, such as the center of a region (e.g., a high-detail, mid-detail or low-detail region), the corner of a region, etc. Additionally, or alternatively, the information regarding the foveated layout of the image frame to be rendered may comprise a display element density for a particular region, a size of the region (e.g., horizontal and/or vertical size) and/or any other information indicative of which display elements are to be addressed simultaneously and thereby operated in the same manner.

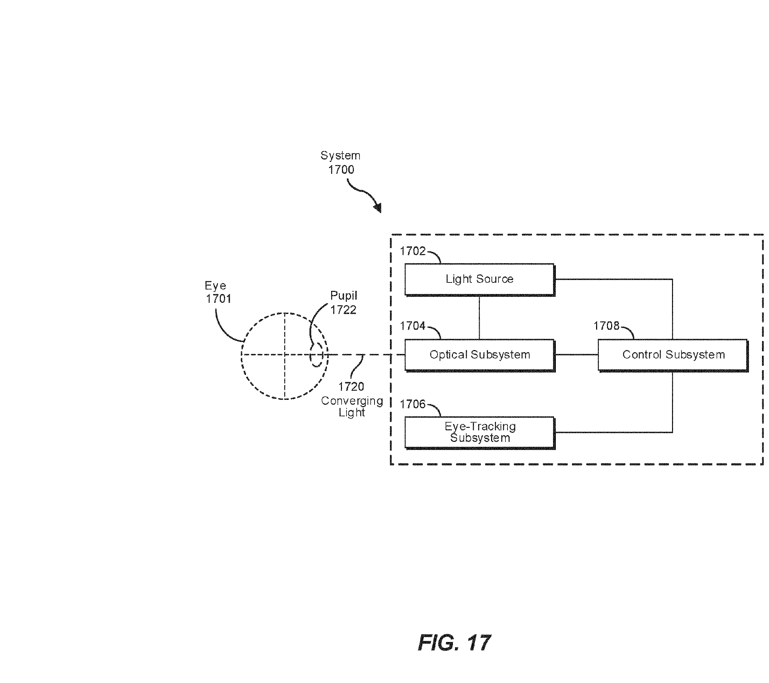

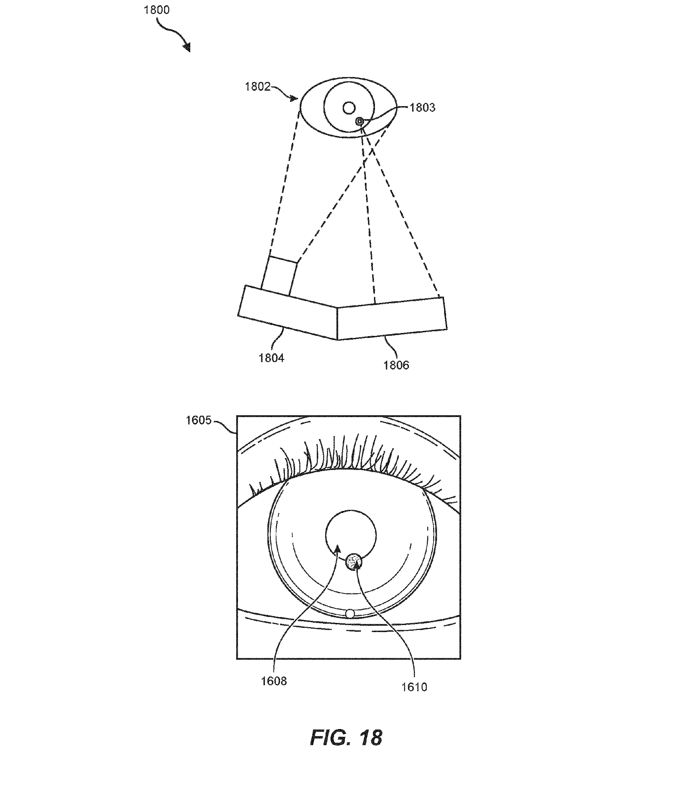

In the example of FIG. 6, the eye tracking system 620 may detect and measure the position of one or both eyes of a wearer of the device comprising system 600. Illustrative eye tracking systems are described below in relation to FIGs. 17 and 18. The eye tracking system 620 may provide eye tracking data to the SoC 610, which comprises an indication of a position of the user's eye or eyes, with which the SoC generates the image data to send to the display driver 630. For instance, the SoC 610 may determine the position of a high-detail region of an image frame based on a position of the eye or eyes, and generate image data accordingly as described above.

In the example of FIG. 6, controller 632 is configured to generate the Nx clock signal and 1x clock signal described above, and provide these clock signals to the gate circuit 631. The controller 632 is also configured to control the display signal generator to produce display signals, which address display elements in the display 640 along with the gate signals produced by the gate circuit 631. In some examples, the controller 632 may produce the display signals and the gate signals in a synchronized manner (e.g., by operating the display signal generator according to the 1x clock signal). In some examples, the display signal generator 633 may comprise a digital to analog converter configured to convert digital values indicating a color or brightness (e.g., received from the SoC 610) to one or more analog display signals. For example, an RGB digital value may be converted into one or multiple (e.g., three) analog display signals that address a display element (e.g., a pixel or a sub-pixel) of the display 640. Although not shown in FIG. 6, the controller 632 may also be configured to control which of the columns a display signal is routed to.

Although the elements of FIG. 6 are depicted as separate sub-systems, it will be appreciated that these elements need not be implemented in such a manner. For example, the display driver 630 may be implemented as an integrated circuit that implements at least the gate circuit 631, the controller 632 and the display signal generator 633.

Features from any of the examples described herein may be used in combination with one another in accordance with the general principles described herein. These and other examples, features, and advantages will be more fully understood upon reading the following detailed description in conjunction with the accompanying drawings and claims.

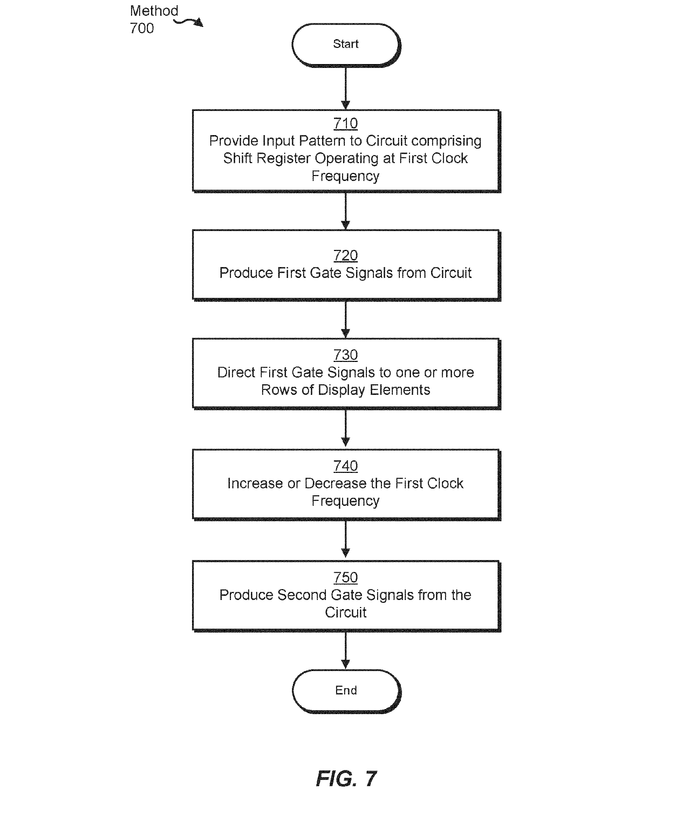

FIG. 7 is a flow diagram of an exemplary computer-implemented method 700 for rendering an image frame in a foveated display, according to the techniques described herein. The steps shown in FIG. 7 may be performed by any suitable computer-executable code and/or computing system, including the system(s) illustrated in FIG. 6. In one example, each of the steps shown in FIG. 7 may represent an algorithm whose structure includes and/or is represented by multiple sub-steps.

Method 700 begins with act 710 in which an input pattern is provided to a circuit comprising a shift register operating at a first clock frequency. For example, the input pattern may be provided as input to gate circuit 300, which comprises a shift register including flip flops 311, 312, 313, etc., and which operates at a first clock frequency of the Nx clock 330. In act 720, one or more first gate signals are produced from the circuit. For example, the first gate signal(s) may be produced from one or more of a plurality of flip flops that are each coupled to a respective flip flop in the shift register (e.g., from one or more of flip flops 321, 322, 323, etc. in gate circuit 300).

In act 730, the first gate signals generated in act 720 are directed to one or more rows of display elements of a display. More generally, the first gate signals may be directed to one or more subsets of display elements of a display. In act 740, the first clock frequency is increased or decreased. For instance, the frequency of the Nx clock signal in gate circuit 300 may be increased or decreased. According to some examples, the circuit may comprise components that operate accordingly to another clock signal (e.g., clock 1x) and the first clock frequency may be adjusted to an integer multiple of the frequency of the other clock signal.

In act 750, one or more second gate signals are produced from the circuit. For example, the second gate signal(s) may be produced from one or more of a plurality of flip flops that are each coupled to a respective flip flop in the shift register (e.g., from one or more of flip flops 321, 322, 323, etc. in gate circuit 300).

It will be appreciated that references herein to driving multiple rows or columns of display elements at the "same time" or "simultaneously" refer to operations that cause each of the rows and/or columns to be addressed at the same time. The signals that drive the rows and/or columns need not necessarily be initiated or end at the same time to be considered to be produced at the "same time" or "simultaneously." For example, two signals that both trigger at their leading edges at the same time may end at different times without affecting their simultaneous addressing. Similarly, two signals that both trigger at their falling edges at the same time may start at different times without affecting their simultaneous addressing.

Embodiments of the present disclosure may include or be implemented in conjunction with various types of Artificial-Reality (AR) systems. AR may be any superimposed functionality and/or sensory-detectable content presented by an artificial-reality system within a user's physical surroundings. In other words, AR is a form of reality that has been adjusted in some manner before presentation to a user. AR can include and/or represent virtual reality (VR), augmented reality, mixed AR (MAR), or some combination and/or variation of these types of realities. Similarly, AR environments may include VR environments (including non-immersive, semi-immersive, and fully immersive VR environments), augmented-reality environments (including marker-based augmented-reality environments, markerless augmented-reality environments, location-based augmented-reality environments, and projection-based augmented-reality environments), hybrid-reality environments, and/or any other type or form of mixed- or alternative-reality environments.

AR content may include completely computer-generated content or computer-generated content combined with captured (e.g., real-world) content. Such AR content may include video, audio, haptic feedback, or some combination thereof, any of which may be presented in a single channel or in multiple channels (such as stereo video that produces a three-dimensional (3D) effect to the viewer). Additionally, In some examples, AR may also be associated with applications, products, accessories, services, or some combination thereof, that are used to, for example, create content in an artificial reality and/or are otherwise used in (e.g., to perform activities in) an artificial reality.

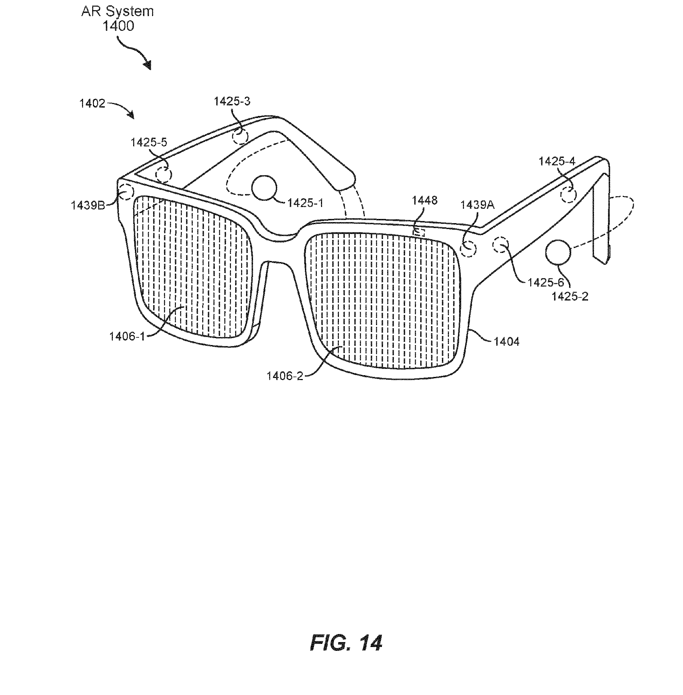

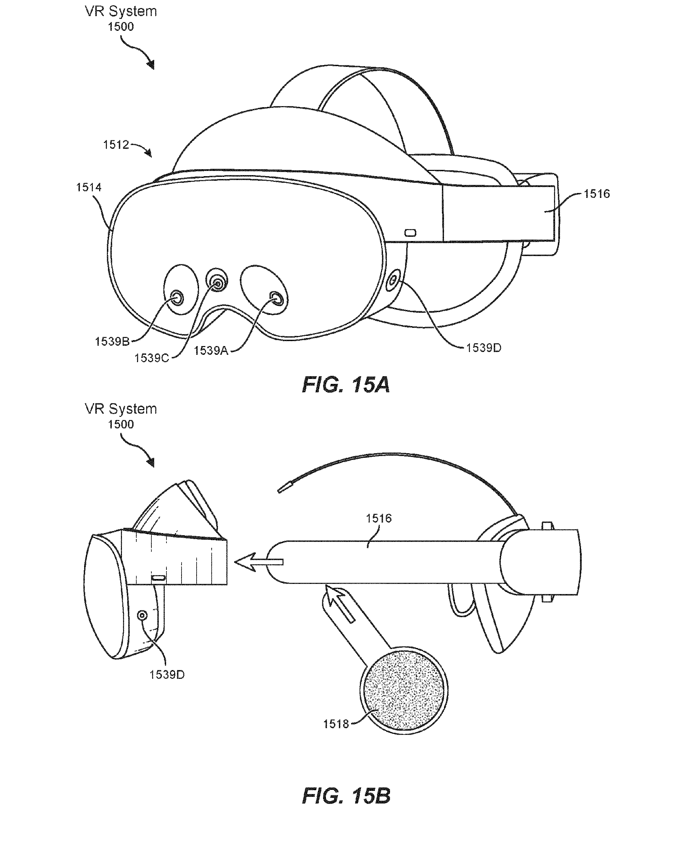

AR systems may be implemented in a variety of different form factors and configurations. Some AR systems may be designed to work without near-eye displays (NEDs). Other AR systems may include a NED that also provides visibility into the real world (such as, e.g., augmented-reality system 1400 in FIG. 14) or that visually immerses a user in an artificial reality (such as, e.g., virtual-reality system 1500 in FIGS. 15A and 15B). While some AR devices may be self-contained systems, other AR devices may communicate and/or coordinate with external devices to provide an AR experience to a user. Examples of such external devices include handheld controllers, mobile devices, desktop computers, devices worn by a user, devices worn by one or more other users, and/or any other suitable external system.

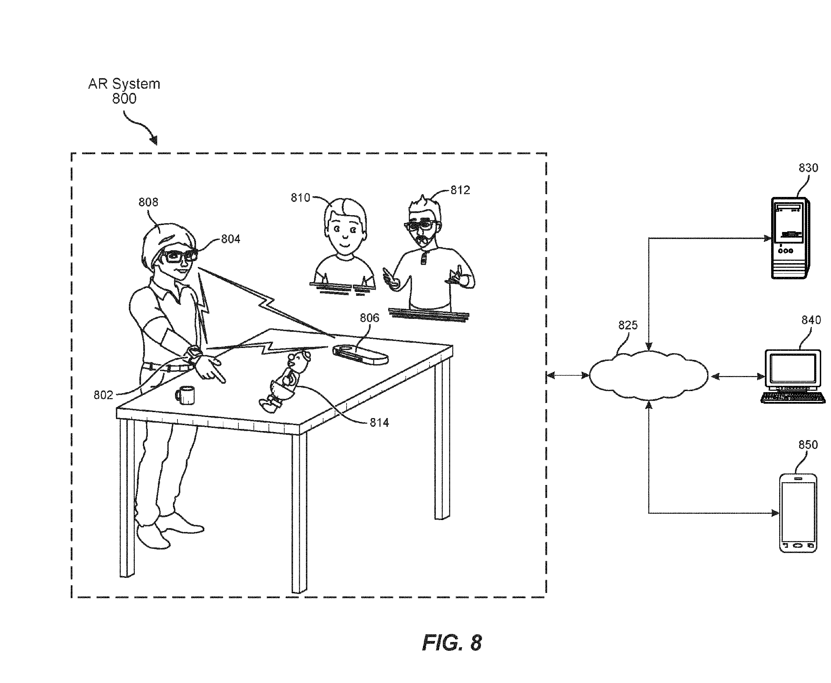

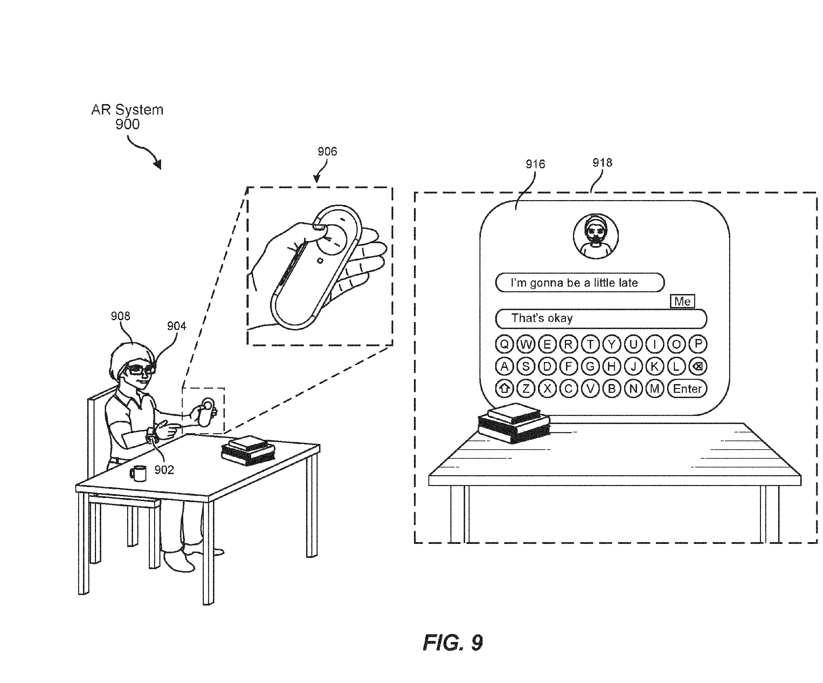

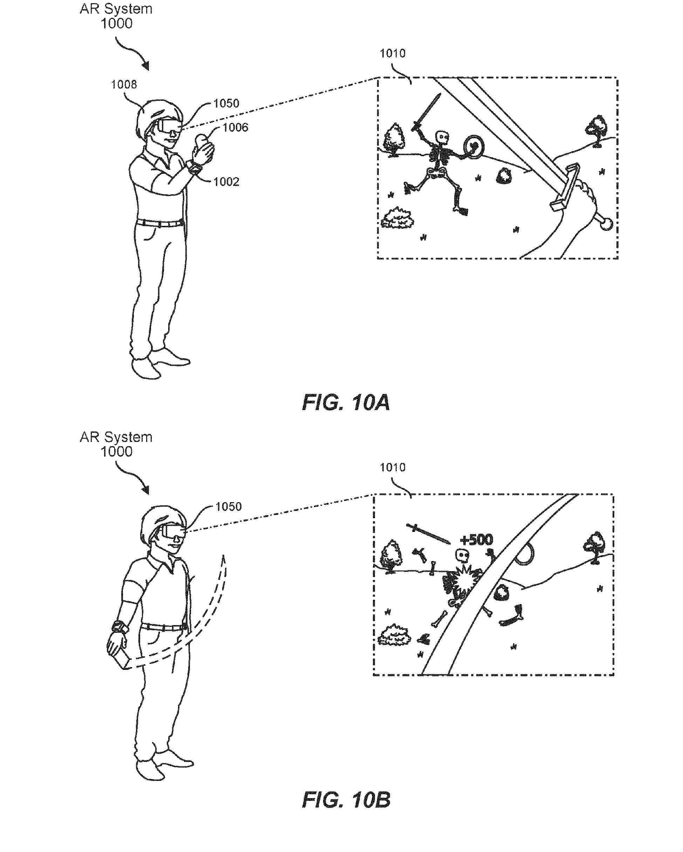

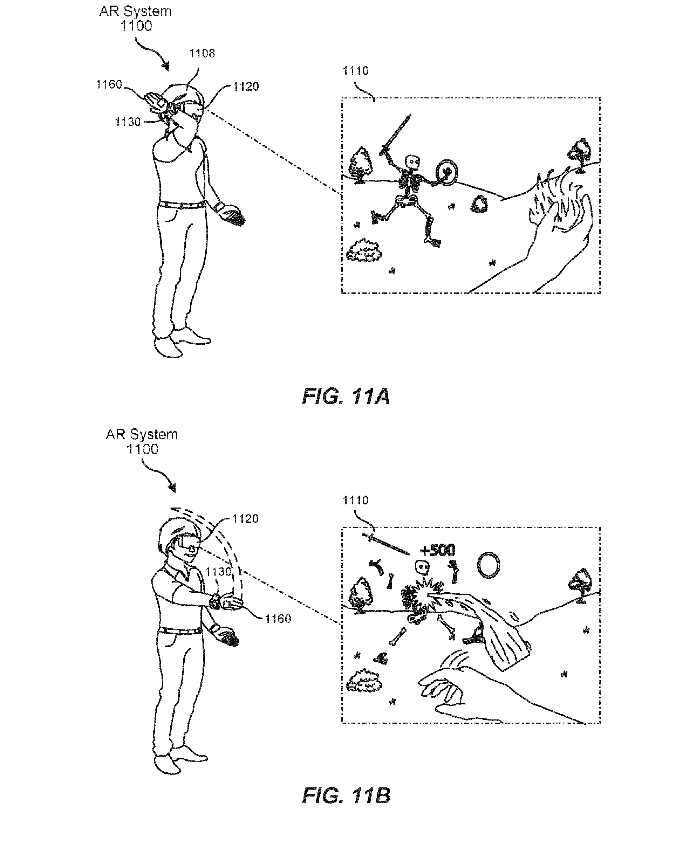

FIGS. 8-11B illustrate example artificial-reality (AR) systems in accordance with some examples. FIG. 8 shows a first AR system 800 and first example user interactions using a wrist-wearable device 802, a head-wearable device (e.g., AR glasses 1400), and/or a handheld intermediary processing device (HIPD) 806. FIG. 9 shows a second AR system 900 and second example user interactions using a wrist-wearable device 902, AR glasses 904, and/or an HIPD 906. FIGS. 10A and 10B show a third AR system 1000 and third example user 1008 interactions using a wrist-wearable device 1002, a head-wearable device (e.g., VR headset 1050), and/or an HIPD 1006. FIGS. 11A and 11B show a fourth AR system 1100 and fourth example user 1108 interactions using a wrist-wearable device 1130, VR headset 1120, and/or a haptic device 1160 (e.g., wearable gloves).

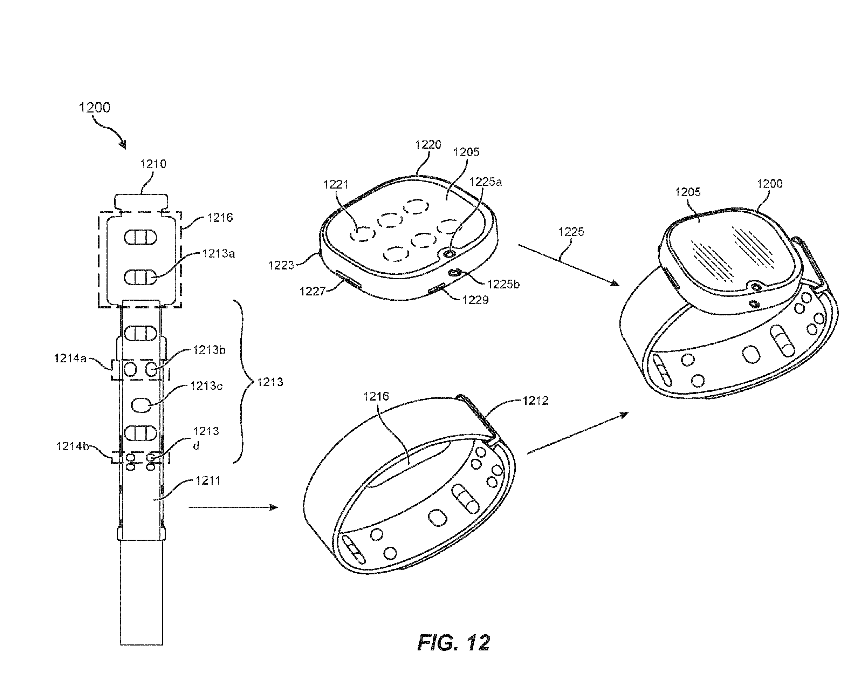

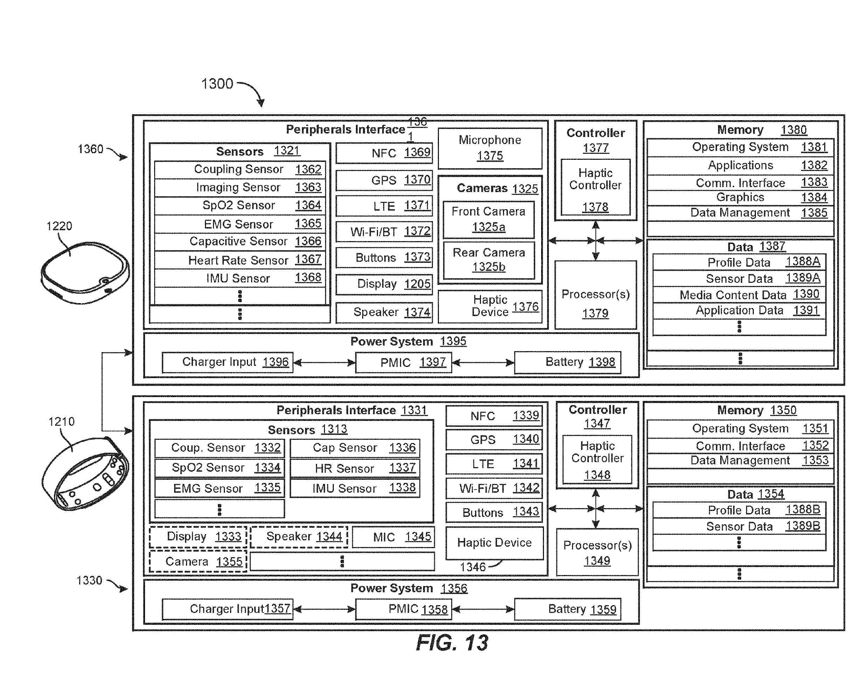

A wrist-wearable device 1200, which can be used for wrist-wearable device 802, 902, 1002, 1130, and one or more of its components, are described below in reference to FIGS. 12 and 13; head-wearable devices 1400 and 1500, which can respectively be used for AR glasses 804, 904 or VR headset 1050, 1120, and their one or more components are described below in reference to FIGS. 14-16.

Referring to FIG. 8, wrist-wearable device 802, AR glasses 804, and/or HIPD 806 can communicatively couple via a network 825 (e.g., cellular, near field, Wi-Fi, personal area network, wireless LAN, etc.). Additionally, wrist-wearable device 802, AR glasses 804, and/or HIPD 806 can also communicatively couple with one or more servers 830, computers 840 (e.g., laptops, computers, etc.), mobile devices 850 (e.g., smartphones, tablets, etc.), and/or other electronic devices via network 825 (e.g., cellular, near field, Wi-Fi, personal area network, wireless LAN, etc.).

In FIG. 8, a user 808 is shown wearing wrist-wearable device 802 and AR glasses 804 and having HIPD 806 on their desk. The wrist-wearable device 802, AR glasses 804, and HIPD 806 facilitate user interaction with an AR environment. In particular, as shown by first AR system 800, wrist-wearable device 802, AR glasses 804, and/or HIPD 806 cause presentation of one or more avatars 810, digital representations of contacts 812, and virtual objects 814. As discussed below, user 808 can interact with one or more avatars 810, digital representations of contacts 812, and virtual objects 814 via wrist-wearable device 802, AR glasses 804, and/or HIPD 806.

User 808 can use any of wrist-wearable device 802, AR glasses 804, and/or HIPD 806 to provide user inputs. For example, user 808 can perform one or more hand gestures that are detected by wrist-wearable device 802 (e.g., using one or more EMG sensors and/or IMUs, described below in reference to FIGS. 12 and 13) and/or AR glasses 804 (e.g., using one or more image sensor or camera, described below in reference to FIGS. 14-10) to provide a user input. Alternatively, or additionally, user 808 can provide a user input via one or more touch surfaces of wrist-wearable device 802, AR glasses 804, HIPD 806, and/or voice commands captured by a microphone of wrist-wearable device 802, AR glasses 804, and/or HIPD 806. In some examples, wrist-wearable device 802, AR glasses 804, and/or HIPD 806 include a digital assistant to help user 808 in providing a user input (e.g., completing a sequence of operations, suggesting different operations or commands, providing reminders, confirming a command, etc.). In some examples, user 808 can provide a user input via one or more facial gestures and/or facial expressions. For example, cameras of wrist-wearable device 802, AR glasses 804, and/or HIPD 806 can track eyes of user 808 for navigating a user interface.

Wrist-wearable device 802, AR glasses 804, and/or HIPD 806 can operate alone or in conjunction to allow user 808 to interact with the AR environment. In some examples, HIPD 806 is configured to operate as a central hub or control center for the wrist-wearable device 802, AR glasses 804, and/or another communicatively coupled device. For example, user 808 can provide an input to interact with the AR environment at any of wrist-wearable device 802, AR glasses 804, and/or HIPD 806, and HIPD 806 can identify one or more back-end and front-end tasks to cause the performance of the requested interaction and distribute instructions to cause the performance of the one or more back-end and front-end tasks at wrist-wearable device 802, AR glasses 804, and/or HIPD 806. In some examples, a back-end task is a background processing task that is not perceptible by the user (e.g., rendering content, decompression, compression, etc.), and a front-end task is a user-facing task that is perceptible to the user (e.g., presenting information to the user, providing feedback to the user, etc.). HIPD 806 can perform the back-end tasks and provide wrist-wearable device 802 and/or AR glasses 804 operational data corresponding to the performed back-end tasks such that wrist-wearable device 802 and/or AR glasses 804 can perform the front-end tasks. In this way, HIPD 806, which has more computational resources and greater thermal headroom than wrist-wearable device 802 and/or AR glasses 804, performs computationally intensive tasks and reduces the computer resource utilization and/or power usage of wrist-wearable device 802 and/or AR glasses 804.

In the example shown by first AR system 800, HIPD 806 identifies one or more back-end tasks and front-end tasks associated with a user request to initiate an AR video call with one or more other users (represented by avatar 810 and the digital representation of contact 812) and distributes instructions to cause the performance of the one or more back-end tasks and front-end tasks. In particular, HIPD 806 performs back-end tasks for processing and/or rendering image data (and other data) associated with the AR video call and provides operational data associated with the performed back-end tasks to AR glasses 804 such that the AR glasses 804 perform front-end tasks for presenting the AR video call (e.g., presenting avatar 810 and digital representation of contact 812).

In some examples, HIPD 806 can operate as a focal or anchor point for causing the presentation of information. This allows user 808 to be generally aware of where information is presented. For example, as shown in first AR system 800, avatar 810 and the digital representation of contact 812 are presented above HIPD 806. In particular, HIPD 806 and AR glasses 804 operate in conjunction to determine a location for presenting avatar 810 and the digital representation of contact 812. In some examples, information can be presented a predetermined distance from HIPD 806 (e.g., within 5 meters). For example, as shown in first AR system 800, virtual object 814 is presented on the desk some distance from HIPD 806. Similar to the above example, HIPD 806 and AR glasses 804 can operate in conjunction to determine a location for presenting virtual object 814. Alternatively, In some examples, presentation of information is not bound by HIPD 806. More specifically, avatar 810, digital representation of contact 812, and virtual object 814 do not have to be presented within a predetermined distance of HIPD 806.

User inputs provided at wrist-wearable device 802, AR glasses 804, and/or HIPD 806 are coordinated such that the user can use any device to initiate, continue, and/or complete an operation. For example, user 808 can provide a user input to AR glasses 804 to cause AR glasses 804 to present virtual object 814 and, while virtual object 814 is presented by AR glasses 804, user 808 can provide one or more hand gestures via wrist-wearable device 802 to interact and/or manipulate virtual object 814.

FIG. 9 shows a user 908 wearing a wrist-wearable device 902 and AR glasses 904, and holding an HIPD 906. In second AR system 900, the wrist-wearable device 902, AR glasses 904, and/or HIPD 906 are used to receive and/or provide one or more messages to a contact of user 908. In particular, wrist-wearable device 902, AR glasses 904, and/or HIPD 906 detect and coordinate one or more user inputs to initiate a messaging application and prepare a response to a received message via the messaging application.

In some examples, user 908 initiates, via a user input, an application on wrist-wearable device 902, AR glasses 904, and/or HIPD 906 that causes the application to initiate on at least one device. For example, in second AR system 900, user 908 performs a hand gesture associated with a command for initiating a messaging application (represented by messaging user interface 916), wrist-wearable device 902 detects the hand gesture and, based on a determination that user 908 is wearing AR glasses 904, causes AR glasses 904 to present a messaging user interface 916 of the messaging application. AR glasses 904 can present messaging user interface 916 to user 908 via its display (e.g., as shown by a field of view 918 of user 908). In some examples, the application is initiated and executed on the device (e.g., wrist-wearable device 902, AR glasses 904, and/or HIPD 906) that detects the user input to initiate the application, and the device provides another device operational data to cause the presentation of the messaging application. For example, wrist-wearable device 902 can detect the user input to initiate a messaging application, initiate and run the messaging application, and provide operational data to AR glasses 904 and/or HIPD 906 to cause presentation of the messaging application. Alternatively, the application can be initiated and executed at a device other than the device that detected the user input. For example, wrist-wearable device 902 can detect the hand gesture associated with initiating the messaging application and cause HIPD 906 to run the messaging application and coordinate the presentation of the messaging application.

Further, user 908 can provide a user input provided at wrist-wearable device 902, AR glasses 904, and/or HIPD 906 to continue and/or complete an operation initiated at another device. For example, after initiating the messaging application via wrist-wearable device 902 and while AR glasses 904 present messaging user interface 916, user 908 can provide an input at HIPD 906 to prepare a response (e.g., shown by the swipe gesture performed on HIPD 906). Gestures performed by user 908 on HIPD 906 can be provided and/or displayed on another device. For example, a swipe gestured performed on HIPD 906 is displayed on a virtual keyboard of messaging user interface 916 displayed by AR glasses 904.

In some examples, wrist-wearable device 902, AR glasses 904, HIPD 906, and/or any other communicatively coupled device can present one or more notifications to user 908. The notification can be an indication of a new message, an incoming call, an application update, a status update, etc. User 908 can select the notification via wrist-wearable device 902, AR glasses 904, and/or HIPD 906 and can cause presentation of an application or operation associated with the notification on at least one device. For example, user 908 can receive a notification that a message was received at wrist-wearable device 902, AR glasses 904, HIPD 906, and/or any other communicatively coupled device and can then provide a user input at wrist-wearable device 902, AR glasses 904, and/or HIPD 906 to review the notification, and the device detecting the user input can cause an application associated with the notification to be initiated and/or presented at wrist-wearable device 902, AR glasses 904, and/or HIPD 906.

While the above example describes coordinated inputs used to interact with a messaging application, user inputs can be coordinated to interact with any number of applications including, but not limited to, gaming applications, social media applications, camera applications, web-based applications, financial applications, etc. For example, AR glasses 904 can present to user 908 game application data, and HIPD 906 can be used as a controller to provide inputs to the game. Similarly, user 908 can use wrist-wearable device 902 to initiate a camera of AR glasses 904, and user 908 can use wrist-wearable device 902, AR glasses 904, and/or HIPD 906 to manipulate the image capture (e.g., zoom in or out, apply filters, etc.) and capture image data.

Users may interact with the devices disclosed herein in a variety of ways. For example, as shown in FIGS. 10A and 10B, a user 1008 may interact with an AR system 1000 by donning a VR headset 1050 while holding HIPD 1006 and wearing wrist-wearable device 1002. In this example, AR system 1000 may enable a user to interact with a game 1010 by swiping their arm. One or more of VR headset 1050, HIPD 1006, and wrist-wearable device 1002 may detect this gesture and, in response, may display a sword strike in game 1010. Similarly, in FIGS. 11A and 11B, a user 1108 may interact with an AR system 1100 by donning a VR headset 1120 while wearing haptic device 1160 and wrist-wearable device 1130. In this example, AR system 1100 may enable a user to interact with a game 1110 by swiping their arm. One or more of VR headset 1120, haptic device 1160, and wrist-wearable device 1130 may detect this gesture and, in response, may display a spell being cast in game 1010.

Having discussed example AR systems, devices for interacting with such AR systems and other computing systems more generally will now be discussed in greater detail. Some explanations of devices and components that can be included in some or all of the example devices discussed below are explained herein for ease of reference. Certain types of the components described below may be more suitable for a particular set of devices, and less suitable for a different set of devices. But subsequent reference to the components explained here should be considered to be encompassed by the descriptions provided.

In some examples discussed below, example devices and systems, including electronic devices and systems, will be addressed. Such example devices and systems are not intended to be limiting, and one of skill in the art will understand that alternative devices and systems to the example devices and systems described herein may be used to perform the operations and construct the systems and devices that are described herein.

An electronic device may be a device that uses electrical energy to perform a specific function. An electronic device can be any physical object that contains electronic components such as transistors, resistors, capacitors, diodes, and integrated circuits. Examples of electronic devices include smartphones, laptops, digital cameras, televisions, gaming consoles, and music players, as well as the example electronic devices discussed herein. As described herein, an intermediary electronic device may be a device that sits between two other electronic devices and/or a subset of components of one or more electronic devices and facilitates communication, data processing, and/or data transfer between the respective electronic devices and/or electronic components.

An integrated circuit may be an electronic device made up of multiple interconnected electronic components such as transistors, resistors, and capacitors. These components may be etched onto a small piece of semiconductor material, such as silicon. Integrated circuits may include analog integrated circuits, digital integrated circuits, mixed signal integrated circuits, and/or any other suitable type or form of integrated circuit. Examples of integrated circuits include application-specific integrated circuits (ASICs), processing units, central processing units (CPUs), co-processors, and accelerators.

Analog integrated circuits, such as sensors, power management circuits, and operational amplifiers, may process continuous signals and perform analog functions such as amplification, active filtering, demodulation, and mixing. Examples of analog integrated circuits include linear integrated circuits and radio frequency circuits.

Digital integrated circuits, which may be referred to as logic integrated circuits, may include microprocessors, microcontrollers, memory chips, interfaces, power management circuits, programmable devices, and/or any other suitable type or form of integrated circuit. In some examples, examples of integrated circuits include central processing units (CPUs),

Processing units, such as CPUs, may be electronic components that are responsible for executing instructions and controlling the operation of an electronic device (e.g., a computer). There are various types of processors that may be used interchangeably, or may be specifically required, by examples described herein. For example, a processor may be: (i) a general processor designed to perform a wide range of tasks, such as running software applications, managing operating systems, and performing arithmetic and logical operations; (ii) a microcontroller designed for specific tasks such as controlling electronic devices, sensors, and motors; (iii) an accelerator, such as a graphics processing unit (GPU), designed to accelerate the creation and rendering of images, videos, and animations (e.g., virtual-reality animations, such as three-dimensional modeling); (iv) a field-programmable gate array (FPGA) that can be programmed and reconfigured after manufacturing and/or can be customized to perform specific tasks, such as signal processing, cryptography, and machine learning; and/or (v) a digital signal processor (DSP) designed to perform mathematical operations on signals such as audio, video, and radio waves. One or more processors of one or more electronic devices may be used in various examples described herein.

Memory generally refers to electronic components in a computer or electronic device that store data and instructions for the processor to access and manipulate. Examples of memory can include: (i) random access memory (RAM) configured to store data and instructions temporarily; (ii) read-only memory (ROM) configured to store data and instructions permanently (e.g., one or more portions of system firmware, and/or boot loaders) and/or semi-permanently; (iii) flash memory, which can be configured to store data in electronic devices (e.g., USB drives, memory cards, and/or solid-state drives (SSDs)); and/or (iv) cache memory configured to temporarily store frequently accessed data and instructions. Memory, as described herein, can store structured data (e.g., SQL databases, MongoDB databases, GraphQL data, JSON data, etc.). Other examples of data stored in memory can include (i) profile data, including user account data, user settings, and/or other user data stored by the user, (ii) sensor data detected and/or otherwise obtained by one or more sensors, (iii) media content data including stored image data, audio data, documents, and the like, (iv) application data, which can include data collected and/or otherwise obtained and stored during use of an application, and/or any other types of data described herein.

Controllers may be electronic components that manage and coordinate the operation of other components within an electronic device (e.g., controlling inputs, processing data, and/or generating outputs). Examples of controllers can include: (i) microcontrollers, including small, low-power controllers that are commonly used in embedded systems and Internet of Things (IoT) devices; (ii) programmable logic controllers (PLCs) that may be configured to be used in industrial automation systems to control and monitor manufacturing processes; (iii) system-on-a-chip (SoC) controllers that integrate multiple components such as processors, memory, I/O interfaces, and other peripherals into a single chip; and/or (iv) DSPs.

A power system of an electronic device may be configured to convert incoming electrical power into a form that can be used to operate the device. A power system can include various components, such as (i) a power source, which can be an alternating current (AC) adapter or a direct current (DC) adapter power supply, (ii) a charger input, which can be configured to use a wired and/or wireless connection (which may be part of a peripheral interface, such as a USB, micro-USB interface, near-field magnetic coupling, magnetic inductive and magnetic resonance charging, and/or radio frequency (RF) charging), (iii) a power-management integrated circuit, configured to distribute power to various components of the device and to ensure that the device operates within safe limits (e.g., regulating voltage, controlling current flow, and/or managing heat dissipation), and/or (iv) a battery configured to store power to provide usable power to components of one or more electronic devices.

Peripheral interfaces may be electronic components (e.g., of electronic devices) that allow electronic devices to communicate with other devices or peripherals and can provide the ability to input and output data and signals. Examples of peripheral interfaces can include (i) universal serial bus (USB) and/or micro-USB interfaces configured for connecting devices to an electronic device, (ii) Bluetooth interfaces configured to allow devices to communicate with each other, including Bluetooth low energy (BLE), (iii) near field communication (NFC) interfaces configured to be short-range wireless interfaces for operations such as access control, (iv) POGO pins, which may be small, spring-loaded pins configured to provide a charging interface, (v) wireless charging interfaces, (vi) GPS interfaces, (vii) Wi-Fi interfaces for providing a connection between a device and a wireless network, and/or (viii) sensor interfaces.

Sensors may be electronic components (e.g., in and/or otherwise in electronic communication with electronic devices, such as wearable devices) configured to detect physical and environmental changes and generate electrical signals. Examples of sensors can include (i) imaging sensors for collecting imaging data (e.g., including one or more cameras disposed on a respective electronic device), (ii) biopotential-signal sensors, (iii) inertial measurement units (e.g., IMUs) for detecting, for example, angular rate, force, magnetic field, and/or changes in acceleration, (iv) heart rate sensors for measuring a user's heart rate, (v) SpO2 sensors for measuring blood oxygen saturation and/or other biometric data of a user, (vi) capacitive sensors for detecting changes in potential at a portion of a user's body (e.g., a sensor-skin interface), and/or (vii) light sensors (e.g., time-of-flight sensors, infrared light sensors, visible light sensors, etc.).

Biopotential-signal-sensing components may be devices used to measure electrical activity within the body (e.g., biopotential-signal sensors). Some types of biopotential-signal sensors include (i) electroencephalography (EEG) sensors configured to measure electrical activity in the brain to diagnose neurological disorders, (ii) electrocardiography (ECG or EKG) sensors configured to measure electrical activity of the heart to diagnose heart problems, (iii) electromyography (EMG) sensors configured to measure the electrical activity of muscles and to diagnose neuromuscular disorders, and (iv) electrooculography (EOG) sensors configure to measure the electrical activity of eye muscles to detect eye movement and diagnose eye disorders.

An application stored in memory of an electronic device (e.g., software) may include instructions stored in the memory. Examples of such applications include (i) games, (ii) word processors, (iii) messaging applications, (iv) media-streaming applications, (v) financial applications, (vi) calendars. (vii) clocks, and (viii) communication interface modules for enabling wired and/or wireless connections between different respective electronic devices (e.g., IEEE 1402.15.4, Wi-Fi, ZigBee, 6LoWPAN, Thread, Z-Wave, Bluetooth Smart, ISA100.11a, WirelessHART, or MiWi), custom or standard wired protocols (e.g., Ethernet or HomePlug), and/or any other suitable communication protocols).

A communication interface may be a mechanism that enables different systems or devices to exchange information and data with each other, including hardware, software, or a combination of both hardware and software. For example, a communication interface can refer to a physical connector and/or port on a device that enables communication with other devices (e.g., USB, Ethernet, HDMI, Bluetooth). In some examples, a communication interface can refer to a software layer that enables different software programs to communicate with each other (e.g., application programming interfaces (APIs), protocols like HTTP and TCP/IP, etc.).

A graphics module may be a component or software module that is designed to handle graphical operations and/or processes and can include a hardware module and/or a software module.

Non-transitory computer-readable storage media may be physical devices or storage media that can be used to store electronic data in a non-transitory form (e.g., such that the data is stored permanently until it is intentionally deleted or modified).

FIGS. 12 and 13 illustrate an example wrist-wearable device 1200 and an example computer system 1300, in accordance with some examples. Wrist-wearable device 1200 is an instance of wearable device 802 described in FIG. 8 herein, such that the wearable device 802 should be understood to have the features of the wrist-wearable device 1200 and vice versa. FIG. 13 illustrates components of the wrist-wearable device 1200, which can be used individually or in combination, including combinations that include other electronic devices and/or electronic components.

FIG. 12 shows a wearable band 1210 and a watch body 1220 (or capsule) being coupled, as discussed below, to form wrist-wearable device 1200. Wrist-wearable device 1200 can perform various functions and/or operations associated with navigating through user interfaces and selectively opening applications as well as the functions and/or operations described above with reference to FIGS. 8-11B.

As will be described in more detail below, operations executed by wrist-wearable device 1200 can include (i) presenting content to a user (e.g., displaying visual content via a display 1205), (ii) detecting (e.g., sensing) user input (e.g., sensing a touch on peripheral button 1223 and/or at a touch screen of the display 1205, a hand gesture detected by sensors (e.g., biopotential sensors)), (iii) sensing biometric data (e.g., neuromuscular signals, heart rate, temperature, sleep, etc.) via one or more sensors 1213, messaging (e.g., text, speech, video, etc.); image capture via one or more imaging devices or cameras 1225, wireless communications (e.g., cellular, near field, Wi-Fi, personal area network, etc.), location determination, financial transactions, providing haptic feedback, providing alarms, providing notifications, providing biometric authentication, providing health monitoring, providing sleep monitoring, etc.

The above-example functions can be executed independently in watch body 1220, independently in wearable band 1210, and/or via an electronic communication between watch body 1220 and wearable band 1210. In some examples, functions can be executed on wrist-wearable device 1200 while an AR environment is being presented (e.g., via one of AR systems 800 to 1100). The wearable devices described herein can also be used with other types of AR environments.

Wearable band 1210 can be configured to be worn by a user such that an inner surface of a wearable structure 1211 of wearable band 1210 is in contact with the user's skin. In this example, when worn by a user, sensors 1213 may contact the user's skin. In some examples, one or more of sensors 1213 can sense biometric data such as a user's heart rate, a saturated oxygen level, temperature, sweat level, neuromuscular signals, or a combination thereof. One or more of sensors 1213 can also sense data about a user's environment including a user's motion, altitude, location, orientation, gait, acceleration, position, or a combination thereof. In some examples, one or more of sensors 1213 can be configured to track a position and/or motion of wearable band 1210. One or more of sensors 1213 can include any of the sensors defined above and/or discussed below with respect to FIG. 12.

One or more of sensors 1213 can be distributed on an inside and/or an outside surface of wearable band 1210. In some examples, one or more of sensors 1213 are uniformly spaced along wearable band 1210. Alternatively, In some examples, one or more of sensors 1213 are positioned at distinct points along wearable band 1210. As shown in FIG. 12, one or more of sensors 1213 can be the same or distinct. For example, In some examples, one or more of sensors 1213 can be shaped as a pill (e.g., sensor 1213a), an oval, a circle a square, an oblong (e.g., sensor 1213c) and/or any other shape that maintains contact with the user's skin (e.g., such that neuromuscular signal and/or other biometric data can be accurately measured at the user's skin). In some examples, one or more sensors of 1213 are aligned to form pairs of sensors (e.g., for sensing neuromuscular signals based on differential sensing within each respective sensor). For example, sensor 1213b may be aligned with an adjacent sensor to form sensor pair 1214a and sensor 1213d may be aligned with an adjacent sensor to form sensor pair 1214b. In some examples, wearable band 1210 does not have a sensor pair. Alternatively, In some examples, wearable band 1210 has a predetermined number of sensor pairs (one pair of sensors, three pairs of sensors, four pairs of sensors, six pairs of sensors, sixteen pairs of sensors, etc.).

Wearable band 1210 can include any suitable number of sensors 1213. In some examples, the number and arrangement of sensors 1213 depends on the particular application for which wearable band 1210 is used. For instance, wearable band 1210 can be configured as an armband, wristband, or chest-band that include a plurality of sensors 1213 with different number of sensors 1213, a variety of types of individual sensors with the plurality of sensors 1213, and different arrangements for each use case, such as medical use cases as compared to gaming or general day-to-day use cases.

In accordance with some examples, wearable band 1210 further includes an electrical ground electrode and a shielding electrode. The electrical ground and shielding electrodes, like the sensors 1213, can be distributed on the inside surface of the wearable band 1210 such that they contact a portion of the user's skin. For example, the electrical ground and shielding electrodes can be at an inside surface of a coupling mechanism 1216 or an inside surface of a wearable structure 1211. The electrical ground and shielding electrodes can be formed and/or use the same components as sensors 1213. In some examples, wearable band 1210 includes more than one electrical ground electrode and more than one shielding electrode.

Sensors 1213 can be formed as part of wearable structure 1211 of wearable band 1210. In some examples, sensors 1213 are flush or substantially flush with wearable structure 1211 such that they do not extend beyond the surface of wearable structure 1211. While flush with wearable structure 1211, sensors 1213 are still configured to contact the user's skin (e.g., via a skin-contacting surface). Alternatively, In some examples, sensors 1213 extend beyond wearable structure 1211 a predetermined distance (e.g., 0.1 - 2 mm) to make contact and depress into the user's skin. In some examples, sensors 1213 are coupled to an actuator (not shown) configured to adjust an extension height (e.g., a distance from the surface of wearable structure 1211) of sensors 1213 such that sensors 1213 make contact and depress into the user's skin. In some examples, the actuators adjust the extension height between 0.01 mm - 1.2 mm. This may allow a the user to customize the positioning of sensors 1213 to improve the overall comfort of the wearable band 1210 when worn while still allowing sensors 1213 to contact the user's skin. In some examples, sensors 1213 are indistinguishable from wearable structure 1211 when worn by the user.

Wearable structure 1211 can be formed of an elastic material, elastomers, etc., configured to be stretched and fitted to be worn by the user. In some examples, wearable structure 1211 is a textile or woven fabric. As described above, sensors 1213 can be formed as part of a wearable structure 1211. For example, sensors 1213 can be molded into the wearable structure 1211, be integrated into a woven fabric (e.g., sensors 1213 can be sewn into the fabric and mimic the pliability of fabric and can and/or be constructed from a series woven strands of fabric).

Wearable structure 1211 can include flexible electronic connectors that interconnect sensors 1213, the electronic circuitry, and/or other electronic components (described below in reference to FIG. 13) that are enclosed in wearable band 1210. In some examples, the flexible electronic connectors are configured to interconnect sensors 1213, the electronic circuitry, and/or other electronic components of wearable band 1210 with respective sensors and/or other electronic components of another electronic device (e.g., watch body 1220). The flexible electronic connectors are configured to move with wearable structure 1211 such that the user adjustment to wearable structure 1211 (e.g., resizing, pulling, folding, etc.) does not stress or strain the electrical coupling of components of wearable band 1210.

As described above, wearable band 1210 is configured to be worn by a user. In particular, wearable band 1210 can be shaped or otherwise manipulated to be worn by a user. For example, wearable band 1210 can be shaped to have a substantially circular shape such that it can be configured to be worn on the user's lower arm or wrist. Alternatively, wearable band 1210 can be shaped to be worn on another body part of the user, such as the user's upper arm (e.g., around a bicep), forearm, chest, legs, etc. Wearable band 1210 can include a retaining mechanism 1212 (e.g., a buckle, a hook and loop fastener, etc.) for securing wearable band 1210 to the user's wrist or other body part. While wearable band 1210 is worn by the user, sensors 1213 sense data (referred to as sensor data) from the user's skin. In some examples, sensors 1213 of wearable band 1210 obtain (e.g., sense and record) neuromuscular signals.

The sensed data (e.g., sensed neuromuscular signals) can be used to detect and/or determine the user's intention to perform certain motor actions. In some examples, sensors 1213 may sense and record neuromuscular signals from the user as the user performs muscular activations (e.g., movements, gestures, etc.). The detected and/or determined motor actions (e.g., phalange (or digit) movements, wrist movements, hand movements, and/or other muscle intentions) can be used to determine control commands or control information (instructions to perform certain commands after the data is sensed) for causing a computing device to perform one or more input commands. For example, the sensed neuromuscular signals can be used to control certain user interfaces displayed on display 1205 of wrist-wearable device 1200 and/or can be transmitted to a device responsible for rendering an artificial-reality environment (e.g., a head-mounted display) to perform an action in an associated artificial-reality environment, such as to control the motion of a virtual device displayed to the user. The muscular activations performed by the user can include static gestures, such as placing the user's hand palm down on a table, dynamic gestures, such as grasping a physical or virtual object, and covert gestures that are imperceptible to another person, such as slightly tensing a joint by co-contracting opposing muscles or using sub-muscular activations. The muscular activations performed by the user can include symbolic gestures (e.g., gestures mapped to other gestures, interactions, or commands, for example, based on a gesture vocabulary that specifies the mapping of gestures to commands).

The sensor data sensed by sensors 1213 can be used to provide a user with an enhanced interaction with a physical object (e.g., devices communicatively coupled with wearable band 1210) and/or a virtual object in an artificial-reality application generated by an artificial-reality system (e.g., user interface objects presented on the display 1205, or another computing device (e.g., a smartphone)).

In some examples, wearable band 1210 includes one or more haptic devices 1346 (e.g., a vibratory haptic actuator) that are configured to provide haptic feedback (e.g., a cutaneous and/or kinesthetic sensation, etc.) to the user's skin. Sensors 1213 and/or haptic devices 1346 (shown in FIG. 13) can be configured to operate in conjunction with multiple applications including, without limitation, health monitoring, social media, games, and artificial reality (e.g., the applications associated with artificial reality).

Wearable band 1210 can also include coupling mechanism 1216 for detachably coupling a capsule (e.g., a computing unit) or watch body 1220 (via a coupling surface of the watch body 1220) to wearable band 1210. For example, a cradle or a shape of coupling mechanism 1216 can correspond to shape of watch body 1220 of wrist-wearable device 1200. In particular, coupling mechanism 1216 can be configured to receive a coupling surface proximate to the bottom side of watch body 1220 (e.g., a side opposite to a front side of watch body 1220 where display 1205 is located), such that a user can push watch body 1220 downward into coupling mechanism 1216 to attach watch body 1220 to coupling mechanism 1216. In some examples, coupling mechanism 1216 can be configured to receive a top side of the watch body 1220 (e.g., a side proximate to the front side of watch body 1220 where display 1205 is located) that is pushed upward into the cradle, as opposed to being pushed downward into coupling mechanism 1216. In some examples, coupling mechanism 1216 is an integrated component of wearable band 1210 such that wearable band 1210 and coupling mechanism 1216 are a single unitary structure. In some examples, coupling mechanism 1216 is a type of frame or shell that allows watch body 1220 coupling surface to be retained within or on wearable band 1210 coupling mechanism 1216 (e.g., a cradle, a tracker band, a support base, a clasp, etc.).

Coupling mechanism 1216 can allow for watch body 1220 to be detachably coupled to the wearable band 1210 through a friction fit, magnetic coupling, a rotation-based connector, a shear-pin coupler, a retention spring, one or more magnets, a clip, a pin shaft, a hook and loop fastener, or a combination thereof. A user can perform any type of motion to couple the watch body 1220 to wearable band 1210 and to decouple the watch body 1220 from the wearable band 1210. For example, a user can twist, slide, turn, push, pull, or rotate watch body 1220 relative to wearable band 1210, or a combination thereof, to attach watch body 1220 to wearable band 1210 and to detach watch body 1220 from wearable band 1210. Alternatively, as discussed below, In some examples, the watch body 1220 can be decoupled from the wearable band 1210 by actuation of a release mechanism 1229.

Wearable band 1210 can be coupled with watch body 1220 to increase the functionality of wearable band 1210 (e.g., converting wearable band 1210 into wrist-wearable device 1200, adding an additional computing unit and/or battery to increase computational resources and/or a battery life of wearable band 1210, adding additional sensors to improve sensed data, etc.). As described above, wearable band 1210 and coupling mechanism 1216 are configured to operate independently (e.g., execute functions independently) from watch body 1220. For example, coupling mechanism 1216 can include one or more sensors 1213 that contact a user's skin when wearable band 1210 is worn by the user, with or without watch body 1220 and can provide sensor data for determining control commands.

A user can detach watch body 1220 from wearable band 1210 to reduce the encumbrance of wrist-wearable device 1200 to the user. For examples in which watch body 1220 is removable, watch body 1220 can be referred to as a removable structure, such that in these examples wrist-wearable device 1200 includes a wearable portion (e.g., wearable band 1210) and a removable structure (e.g., watch body 1220).

Turning to watch body 1220, in some examples watch body 1220 can have a substantially rectangular or circular shape. Watch body 1220 is configured to be worn by the user on their wrist or on another body part. More specifically, watch body 1220 is sized to be easily carried by the user, attached on a portion of the user's clothing, and/or coupled to wearable band 1210 (forming the wrist-wearable device 1200). As described above, watch body 1220 can have a shape corresponding to coupling mechanism 1216 of wearable band 1210. In some examples, watch body 1220 includes a single release mechanism 1229 or multiple release mechanisms (e.g., two release mechanisms 1229 positioned on opposing sides of watch body 1220, such as spring-loaded buttons) for decoupling watch body 1220 from wearable band 1210. Release mechanism 1229 can include, without limitation, a button, a knob, a plunger, a handle, a lever, a fastener, a clasp, a dial, a latch, or a combination thereof.

A user can actuate release mechanism 1229 by pushing, turning, lifting, depressing, shifting, or performing other actions on release mechanism 1229. Actuation of release mechanism 1229 can release (e.g., decouple) watch body 1220 from coupling mechanism 1216 of wearable band 1210, allowing the user to use watch body 1220 independently from wearable band 1210 and vice versa. For example, decoupling watch body 1220 from wearable band 1210 can allow a user to capture images using rear-facing camera 1225b. Although release mechanism 1229 is shown positioned at a corner of watch body 1220, release mechanism 1229 can be positioned anywhere on watch body 1220 that is convenient for the user to actuate. In addition, In some examples, wearable band 1210 can also include a respective release mechanism for decoupling watch body 1220 from coupling mechanism 1216. In some examples, release mechanism 1229 is optional and watch body 1220 can be decoupled from coupling mechanism 1216 as described above (e.g., via twisting, rotating, etc.).

Watch body 1220 can include one or more peripheral buttons 1223 and 1227 for performing various operations at watch body 1220. For example, peripheral buttons 1223 and 1227 can be used to turn on or wake (e.g., transition from a sleep state to an active state) display 1205, unlock watch body 1220, increase or decrease a volume, increase or decrease a brightness, interact with one or more applications, interact with one or more user interfaces, etc. Additionally or alternatively, In some examples, display 1205 operates as a touch screen and allows the user to provide one or more inputs for interacting with watch body 1220.

In some examples, watch body 1220 includes one or more sensors 1221. Sensors 1221 of watch body 1220 can be the same or distinct from sensors 1213 of wearable band 1210. Sensors 1221 of watch body 1220 can be distributed on an inside and/or an outside surface of watch body 1220. In some examples, sensors 1221 are configured to contact a user's skin when watch body 1220 is worn by the user. For example, sensors 1221 can be placed on the bottom side of watch body 1220 and coupling mechanism 1216 can be a cradle with an opening that allows the bottom side of watch body 1220 to directly contact the user's skin. Alternatively, In some examples, watch body 1220 does not include sensors that are configured to contact the user's skin (e.g., including sensors internal and/or external to the watch body 1220 that are configured to sense data of watch body 1220 and the surrounding environment). In some examples, sensors 1221 are configured to track a position and/or motion of watch body 1220.

Watch body 1220 and wearable band 1210 can share data using a wired communication method (e.g., a Universal Asynchronous Receiver/Transmitter (UART), a USB transceiver, etc.) and/or a wireless communication method (e.g., near field communication, Bluetooth, etc.). For example, watch body 1220 and wearable band 1210 can share data sensed by sensors 1213 and 1221, as well as application and device specific information (e.g., active and/or available applications, output devices (e.g., displays, speakers, etc.), input devices (e.g., touch screens, microphones, imaging sensors, etc.).

In some examples, watch body 1220 can include, without limitation, a front-facing camera 1225a and/or a rear-facing camera 1225b, sensors 1221 (e.g., a biometric sensor, an IMU, a heart rate sensor, a saturated oxygen sensor, a neuromuscular signal sensor, an altimeter sensor, a temperature sensor, a bioimpedance sensor, a pedometer sensor, an optical sensor (e.g., imaging sensor 1363), a touch sensor, a sweat sensor, etc.). In some examples, watch body 1220 can include one or more haptic devices 1376 (e.g., a vibratory haptic actuator) that is configured to provide haptic feedback (e.g., a cutaneous and/or kinesthetic sensation, etc.) to the user. Sensors 1321 and/or haptic device 1376 can also be configured to operate in conjunction with multiple applications including, without limitation, health monitoring applications, social media applications, game applications, and artificial reality applications (e.g., the applications associated with artificial reality).

As described above, watch body 1220 and wearable band 1210, when coupled, can form wrist-wearable device 1200. When coupled, watch body 1220 and wearable band 1210 may operate as a single device to execute functions (operations, detections, communications, etc.) described herein. In some examples, each device may be provided with particular instructions for performing the one or more operations of wrist-wearable device 1200. For example, in accordance with a determination that watch body 1220 does not include neuromuscular signal sensors, wearable band 1210 can include alternative instructions for performing associated instructions (e.g., providing sensed neuromuscular signal data to watch body 1220 via a different electronic device). Operations of wrist-wearable device 1200 can be performed by watch body 1220 alone or in conjunction with wearable band 1210 (e.g., via respective processors and/or hardware components) and vice versa. In some examples, operations of wrist-wearable device 1200, watch body 1220, and/or wearable band 1210 can be performed in conjunction with one or more processors and/or hardware components.

As described below with reference to the block diagram of FIG. 13, wearable band 1210 and/or watch body 1220 can each include independent resources required to independently execute functions. For example, wearable band 1210 and/or watch body 1220 can each include a power source (e.g., a battery), a memory, data storage, a processor (e.g., a central processing unit (CPU)), communications, a light source, and/or input/output devices.

FIG. 13 shows block diagrams of a computing system 1330 corresponding to wearable band 1210 and a computing system 1360 corresponding to watch body 1220 according to some examples. Computing system 1300 of wrist-wearable device 1200 may include a combination of components of wearable band computing system 1330 and watch body computing system 1360, in accordance with some examples.

Watch body 1220 and/or wearable band 1210 can include one or more components shown in watch body computing system 1360. In some examples, a single integrated circuit may include all or a substantial portion of the components of watch body computing system 1360 included in a single integrated circuit. Alternatively, In some examples, components of the watch body computing system 1360 may be included in a plurality of integrated circuits that are communicatively coupled. In some examples, watch body computing system 1360 may be configured to couple (e.g., via a wired or wireless connection) with wearable band computing system 1330, which may allow the computing systems to share components, distribute tasks, and/or perform other operations described herein (individually or as a single device).

Watch body computing system 1360 can include one or more processors 1379, a controller 1377, a peripherals interface 1361, a power system 1395, and memory (e.g., a memory 1380).

Power system 1395 can include a charger input 1396, a power-management integrated circuit (PMIC) 1397, and a battery 1398. In some examples, a watch body 1220 and a wearable band 1210 can have respective batteries (e.g., battery 1398 and 1359) and can share power with each other. Watch body 1220 and wearable band 1210 can receive a charge using a variety of techniques. In some examples, watch body 1220 and wearable band 1210 can use a wired charging assembly (e.g., power cords) to receive the charge. Alternatively, or in addition, watch body 1220 and/or wearable band 1210 can be configured for wireless charging. For example, a portable charging device can be designed to mate with a portion of watch body 1220 and/or wearable band 1210 and wirelessly deliver usable power to battery 1398 of watch body 1220 and/or battery 1359 of wearable band 1210. Watch body 1220 and wearable band 1210 can have independent power systems (e.g., power system 1395 and 1356, respectively) to enable each to operate independently. Watch body 1220 and wearable band 1210 can also share power (e.g., one can charge the other) via respective PMICs (e.g., PMICs 1397 and 1358) and charger inputs (e.g., 1357 and 1396) that can share power over power and ground conductors and/or over wireless charging antennas.

In some examples, peripherals interface 1361 can include one or more sensors 1321. Sensors 1321 can include one or more coupling sensors 1362 for detecting when watch body 1220 is coupled with another electronic device (e.g., a wearable band 1210). Sensors 1321 can include one or more imaging sensors 1363 (e.g., one or more of cameras 1325, and/or separate imaging sensors 1363 (e.g., thermal-imaging sensors)). In some examples, sensors 1321 can include one or more SpO2 sensors 1364. In some examples, sensors 1321 can include one or more biopotential-signal sensors (e.g., EMG sensors 1365, which may be disposed on an interior, user-facing portion of watch body 1220 and/or wearable band 1210). In some examples, sensors 1321 may include one or more capacitive sensors 1366. In some examples, sensors 1321 may include one or more heart rate sensors 1367. In some examples, sensors 1321 may include one or more IMU sensors 1368. In some examples, one or more IMU sensors 1368 can be configured to detect movement of a user's hand or other location where watch body 1220 is placed or held.

In some examples, one or more of sensors 1321 may provide an example human-machine interface. For example, a set of neuromuscular sensors, such as EMG sensors 1365, may be arranged circumferentially around wearable band 1210 with an interior surface of EMG sensors 1365 being configured to contact a user's skin. Any suitable number of neuromuscular sensors may be used (e.g., between 2 and 20 sensors). The number and arrangement of neuromuscular sensors may depend on the particular application for which the wearable device is used. For example, wearable band 1210 can be used to generate control information for controlling an augmented reality system, a robot, controlling a vehicle, scrolling through text, controlling a virtual avatar, or any other suitable control task.

In some examples, neuromuscular sensors may be coupled together using flexible electronics incorporated into the wireless device, and the output of one or more of the sensing components can be optionally processed using hardware signal processing circuitry (e.g., to perform amplification, filtering, and/or rectification). In other examples, at least some signal processing of the output of the sensing components can be performed in software such as processors 1379. Thus, signal processing of signals sampled by the sensors can be performed in hardware, software, or by any suitable combination of hardware and software, as aspects of the technology described herein are not limited in this respect.

Neuromuscular signals may be processed in a variety of ways. For example, the output of EMG sensors 1365 may be provided to an analog front end, which may be configured to perform analog processing (e.g., amplification, noise reduction, filtering, etc.) on the recorded signals. The processed analog signals may then be provided to an analog-to-digital converter, which may convert the analog signals to digital signals that can be processed by one or more computer processors. Furthermore, although this example is as discussed in the context of interfaces with EMG sensors, the examples described herein can also be implemented in wearable interfaces with other types of sensors including, but not limited to, mechanomyography (MMG) sensors, sonomyography (SMG) sensors, and electrical impedance tomography (EIT) sensors.

In some examples, peripherals interface 1361 includes a near-field communication (NFC) component 1369, a global-position system (GPS) component 1370, a long-term evolution (LTE) component 1371, and/or a Wi-Fi and/or Bluetooth communication component 1372. In some examples, peripherals interface 1361 includes one or more buttons 1373 (e.g., peripheral buttons 1223 and 1227 in FIG. 12), which, when selected by a user, cause operation to be performed at watch body 1220. In some examples, the peripherals interface 1361 includes one or more indicators, such as a light emitting diode (LED), to provide a user with visual indicators (e.g., message received, low battery, active microphone and/or camera, etc.).

Watch body 1220 can include at least one display 1205 for displaying visual representations of information or data to a user, including user-interface elements and/or three-dimensional virtual objects. The display can also include a touch screen for inputting user inputs, such as touch gestures, swipe gestures, and the like. Watch body 1220 can include at least one speaker 1374 and at least one microphone 1375 for providing audio signals to the user and receiving audio input from the user. The user can provide user inputs through microphone 1375 and can also receive audio output from speaker 1374 as part of a haptic event provided by haptic controller 1378. Watch body 1220 can include at least one camera 1325, including a front camera 1325a and a rear camera 1325b. Cameras 1325 can include ultra-wide-angle cameras, wide angle cameras, fish-eye cameras, spherical cameras, telephoto cameras, depth-sensing cameras, or other types of cameras.

Watch body computing system 1360 can include one or more haptic controllers 1378 and associated componentry (e.g., haptic devices 1376) for providing haptic events at watch body 1220 (e.g., a vibrating sensation or audio output in response to an event at the watch body 1220). Haptic controllers 1378 can communicate with one or more haptic devices 1376, such as electroacoustic devices, including a speaker of the one or more speakers 1374 and/or other audio components and/or electromechanical devices that convert energy into linear motion such as a motor, solenoid, electroactive polymer, piezoelectric actuator, electrostatic actuator, or other tactile output generating components (e.g., a component that converts electrical signals into tactile outputs on the device). Haptic controller 1378 can provide haptic events to that are capable of being sensed by a user of watch body 1220. In some examples, one or more haptic controllers 1378 can receive input signals from an application of applications 1382.

In some examples, wearable band computing system 1330 and/or watch body computing system 1360 can include memory 1380, which can be controlled by one or more memory controllers of controllers 1377. In some examples, software components stored in memory 1380 include one or more applications 1382 configured to perform operations at the watch body 1220. In some examples, one or more applications 1382 may include games, word processors, messaging applications, calling applications, web browsers, social media applications, media streaming applications, financial applications, calendars, clocks, etc. In some examples, software components stored in memory 1380 include one or more communication interface modules 1383 as defined above. In some examples, software components stored in memory 1380 include one or more graphics modules 1384 for rendering, encoding, and/or decoding audio and/or visual data and one or more data management modules 1385 for collecting, organizing, and/or providing access to data 1387 stored in memory 1380. In some examples, one or more of applications 1382 and/or one or more modules can work in conjunction with one another to perform various tasks at the watch body 1220.

In some examples, software components stored in memory 1380 can include one or more operating systems 1381 (e.g., a Linux-based operating system, an Android operating system, etc.). Memory 1380 can also include data 1387. Data 1387 can include profile data 1388A, sensor data 1389A, media content data 1390, and application data 1391.

It should be appreciated that watch body computing system 1360 is an example of a computing system within watch body 1220, and that watch body 1220 can have more or fewer components than shown in watch body computing system 1360, can combine two or more components, and/or can have a different configuration and/or arrangement of the components. The various components shown in watch body computing system 1360 are implemented in hardware, software, firmware, or a combination thereof, including one or more signal processing and/or application-specific integrated circuits.

Turning to the wearable band computing system 1330, one or more components that can be included in wearable band 1210 are shown. Wearable band computing system 1330 can include more or fewer components than shown in watch body computing system 1360, can combine two or more components, and/or can have a different configuration and/or arrangement of some or all of the components. In some examples, all, or a substantial portion of the components of wearable band computing system 1330 are included in a single integrated circuit. Alternatively, In some examples, components of wearable band computing system 1330 are included in a plurality of integrated circuits that are communicatively coupled. As described above, In some examples, wearable band computing system 1330 is configured to couple (e.g., via a wired or wireless connection) with watch body computing system 1360, which allows the computing systems to share components, distribute tasks, and/or perform other operations described herein (individually or as a single device).

Wearable band computing system 1330, similar to watch body computing system 1360, can include one or more processors 1349, one or more controllers 1347 (including one or more haptics controllers 1348), a peripherals interface 1331 that can includes one or more sensors 1313 and other peripheral devices, a power source (e.g., a power system 1356), and memory (e.g., a memory 1350) that includes an operating system (e.g., an operating system 1351), data (e.g., data 1354 including profile data 1388B, sensor data 1389B, etc.), and one or more modules (e.g., a communications interface module 1352, a data management module 1353, etc.).

One or more of sensors 1313 can be analogous to sensors 1321 of watch body computing system 1360. For example, sensors 1313 can include one or more coupling sensors 1332, one or more SpO2 sensors 1334, one or more EMG sensors 1335, one or more capacitive sensors 1336, one or more heart rate sensors 1337, and one or more IMU sensors 1338.

Peripherals interface 1331 can also include other components analogous to those included in peripherals interface 1361 of watch body computing system 1360, including an NFC component 1339, a GPS component 1340, an LTE component 1341, a Wi-Fi and/or Bluetooth communication component 1342, and/or one or more haptic devices 1346 as described above in reference to peripherals interface 1361. In some examples, peripherals interface 1331 includes one or more buttons 1343, a display 1333, a speaker 1344, a microphone 1345, and a camera 1355. In some examples, peripherals interface 1331 includes one or more indicators, such as an LED.

It should be appreciated that wearable band computing system 1330 is an example of a computing system within wearable band 1210, and that wearable band 1210 can have more or fewer components than shown in wearable band computing system 1330, combine two or more components, and/or have a different configuration and/or arrangement of the components. The various components shown in wearable band computing system 1330 can be implemented in one or more of a combination of hardware, software, or firmware, including one or more signal processing and/or application-specific integrated circuits.

Wrist-wearable device 1200 with respect to FIG. 12 is an example of wearable band 1210 and watch body 1220 coupled together, so wrist-wearable device 1200 will be understood to include the components shown and described for wearable band computing system 1330 and watch body computing system 1360. In some examples, wrist-wearable device 1200 has a split architecture (e.g., a split mechanical architecture, a split electrical architecture, etc.) between watch body 1220 and wearable band 1210. In other words, all of the components shown in wearable band computing system 1330 and watch body computing system 1360 can be housed or otherwise disposed in a combined wrist-wearable device 1200 or within individual components of watch body 1220, wearable band 1210, and/or portions thereof (e.g., a coupling mechanism 1216 of wearable band 1210).

The techniques described above can be used with any device for sensing neuromuscular signals but could also be used with other types of wearable devices for sensing neuromuscular signals (such as body-wearable or head-wearable devices that might have neuromuscular sensors closer to the brain or spinal column).

In some examples, wrist-wearable device 1200 can be used in conjunction with a head-wearable device (e.g., AR glasses 1400 and VR system 1510) and/or an HIPD, and wrist-wearable device 1200 can also be configured to be used to allow a user to control any aspect of the artificial reality (e.g., by using EMG-based gestures to control user interface objects in the artificial reality and/or by allowing a user to interact with the touchscreen on the wrist-wearable device to also control aspects of the artificial reality). Having thus described example wrist-wearable devices, attention will now be turned to example head-wearable devices, such AR glasses 1400 and VR headset 1510.

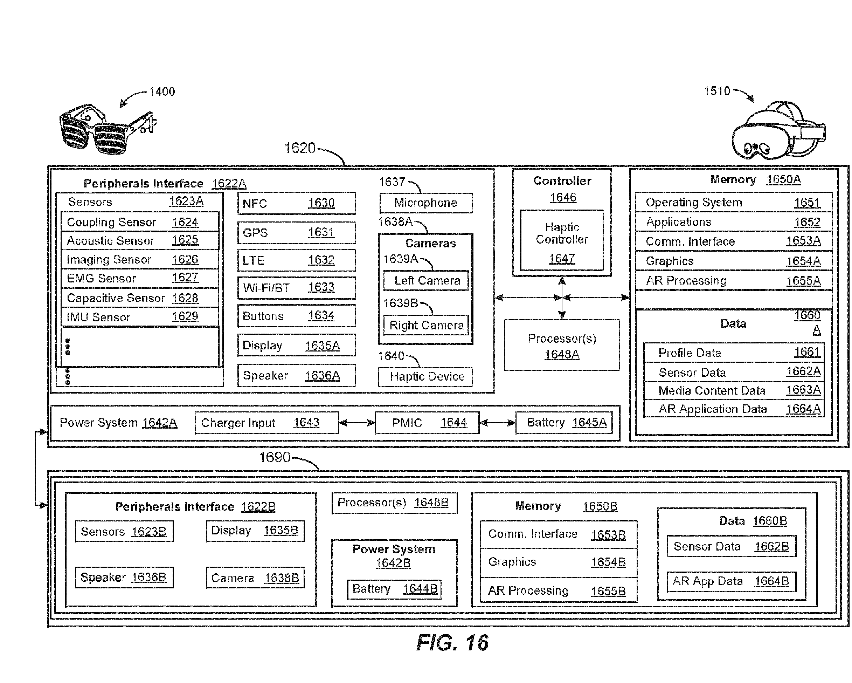

FIGS. 14 to 16 show example artificial-reality systems, which can be used as or in connection with wrist-wearable device 1200. In some examples, AR system 1400 includes an eyewear device 1402, as shown in FIG. 14. In some examples, VR system 1510 includes a head-mounted display (HMD) 1512, as shown in FIGS. 15A and 15B. In some examples, AR system 1400 and VR system 1510 can include one or more analogous components (e.g., components for presenting interactive artificial-reality environments, such as processors, memory, and/or presentation devices, including one or more displays and/or one or more waveguides), some of which are described in more detail with respect to FIG. 16. As described herein, a head-wearable device can include components of eyewear device 1402 and/or head-mounted display 1512. Some examples of head-wearable devices do not include any displays, including any of the displays described with respect to AR system 1400 and/or VR system 1510. While the example artificial-reality systems are respectively described herein as AR system 1400 and VR system 1510, either or both of the example AR systems described herein can be configured to present fully-immersive virtual-reality scenes presented in substantially all of a user's field of view or subtler augmented-reality scenes that are presented within a portion, less than all, of the user's field of view.

FIG. 14 show an example visual depiction of AR system 1400, including an eyewear device 1402 (which may also be described herein as augmented-reality glasses, and/or smart glasses). AR system 1400 can include additional electronic components that are not shown in FIG. 14, such as a wearable accessory device and/or an intermediary processing device, in electronic communication or otherwise configured to be used in conjunction with the eyewear device 1402. In some examples, the wearable accessory device and/or the intermediary processing device may be configured to couple with eyewear device 1402 via a coupling mechanism in electronic communication with a coupling sensor 1624 (FIG. 16), where coupling sensor 1624 can detect when an electronic device becomes physically or electronically coupled with eyewear device 1402. In some examples, eyewear device 1402 can be configured to couple to a housing 1690 (FIG. 16), which may include one or more additional coupling mechanisms configured to couple with additional accessory devices. The components shown in FIG. 14 can be implemented in hardware, software, firmware, or a combination thereof, including one or more signal-processing components and/or application-specific integrated circuits (ASICs).

Eyewear device 1402 includes mechanical glasses components, including a frame 1404 configured to hold one or more lenses (e.g., one or both lenses 1406-1 and 1406-2). One of ordinary skill in the art will appreciate that eyewear device 1402 can include additional mechanical components, such as hinges configured to allow portions of frame 1404 of eyewear device 1402 to be folded and unfolded, a bridge configured to span the gap between lenses 1406-1 and 1406-2 and rest on the user's nose, nose pads configured to rest on the bridge of the nose and provide support for eyewear device 1402, earpieces configured to rest on the user's ears and provide additional support for eyewear device 1402, temple arms configured to extend from the hinges to the earpieces of eyewear device 1402, and the like. One of ordinary skill in the art will further appreciate that some examples of AR system 1400 can include none of the mechanical components described herein. For example, smart contact lenses configured to present artificial reality to users may not include any components of eyewear device 1402.

Eyewear device 1402 includes electronic components, many of which will be described in more detail below with respect to FIG. 16. Some example electronic components are illustrated in FIG. 14, including acoustic sensors 1425-1, 1425-2, 1425-3, 1425-4, 1425-5, and 1425-6, which can be distributed along a substantial portion of the frame 1404 of eyewear device 1402. Eyewear device 1402 also includes a left camera 1439A and a right camera 1439B, which are located on different sides of the frame 1404. Eyewear device 1402 also includes a processor 1448 (or any other suitable type or form of integrated circuit) that is embedded into a portion of the frame 1404.

FIGS. 15A and 15B show a VR system 1510 that includes a head-mounted display (HMD) 1512 (e.g., also referred to herein as an artificial-reality headset, a head-wearable device, a VR headset, etc.), in accordance with some examples. As noted, some artificial-reality systems (e.g., AR system 1400) may, instead of blending an artificial reality with actual reality, substantially replace one or more of a user's visual and/or other sensory perceptions of the real world with a virtual experience (e.g., AR systems 1000 and 1100).

HMD 1512 includes a front body 1514 and a frame 1516 (e.g., a strap or band) shaped to fit around a user's head. In some examples, front body 1514 and/or frame 1516 include one or more electronic elements for facilitating presentation of and/or interactions with an AR and/or VR system (e.g., displays, IMUs, tracking emitter or detectors). In some examples, HMD 1512 includes output audio transducers (e.g., an audio transducer 1518), as shown in FIG. 15B. In some examples, one or more components, such as the output audio transducer(s) 1518 and frame 1516, can be configured to attach and detach (e.g., are detachably attachable) to HMD 1512 (e.g., a portion or all of frame 1516, and/or audio transducer 1518), as shown in FIG. 15B. In some examples, coupling a detachable component to HMD 1512 causes the detachable component to come into electronic communication with HMD 1512.

FIGS. 15A and 15B also show that VR system 1510 includes one or more cameras, such as left camera 1539A and right camera 1539B, which can be analogous to left and right cameras 1439A and 1439B on frame 1404 of eyewear device 1402. In some examples, VR system 1510 includes one or more additional cameras (e.g., cameras 1539C and 1539D), which can be configured to augment image data obtained by left and right cameras 1539A and 1539B by providing more information. For example, camera 1539C can be used to supply color information that is not discerned by cameras 1539A and 1539B. In some examples, one or more of cameras 1539A to 1539D can include an optional IR cut filter configured to remove IR light from being received at the respective camera sensors.

FIG. 16 illustrates a computing system 1620 and an optional housing 1690, each of which show components that can be included in AR system 1400 and/or VR system 1510. In some examples, more or fewer components can be included in optional housing 1690 depending on practical restraints of the respective AR system being described.

In some examples, computing system 1620 can include one or more peripherals interfaces 1622A and/or optional housing 1690 can include one or more peripherals interfaces 1622B. Each of computing system 1620 and optional housing 1690 can also include one or more power systems 1642A and 1642B, one or more controllers 1646 (including one or more haptic controllers 1647), one or more processors 1648A and 1648B (as defined above, including any of the examples provided), and memory 1650A and 1650B, which can all be in electronic communication with each other. For example, the one or more processors 1648A and 1648B can be configured to execute instructions stored in memory 1650A and 1650B, which can cause a controller of one or more of controllers 1646 to cause operations to be performed at one or more peripheral devices connected to peripherals interface 1622A and/or 1622B. In some examples, each operation described can be powered by electrical power provided by power system 1642A and/or 1642B.

In some examples, peripherals interface 1622A can include one or more devices configured to be part of computing system 1620, some of which have been defined above and/or described with respect to the wrist-wearable devices shown in FIGS. 12 and 13. For example, peripherals interface 1622A can include one or more sensors 1623A. Some example sensors 1623A include one or more coupling sensors 1624, one or more acoustic sensors 1625, one or more imaging sensors 1626, one or more EMG sensors 1627, one or more capacitive sensors 1628, one or more IMU sensors 1629, and/or any other types of sensors explained above or described with respect to any other examples discussed herein.

In some examples, peripherals interfaces 1622A and 1622B can include one or more additional peripheral devices, including one or more NFC devices 1630, one or more GPS devices 1631, one or more LTE devices 1632, one or more Wi-Fi and/or Bluetooth devices 1633, one or more buttons 1634 (e.g., including buttons that are slidable or otherwise adjustable), one or more displays 1635A and 1635B, one or more speakers 1636A and 1636B, one or more microphones 1637, one or more cameras 1638A and 1638B (e.g., including the left camera 1639A and/or a right camera 1639B), one or more haptic devices 1640, and/or any other types of peripheral devices defined above or described with respect to any other examples discussed herein.

AR systems can include a variety of types of visual feedback mechanisms (e.g., presentation devices). For example, display devices in AR system 1400 and/or VR system 1510 can include one or more liquid-crystal displays (LCDs), light emitting diode (LED) displays, organic LED (OLED) displays, and/or any other suitable types of display screens. Artificial-reality systems can include a single display screen (e.g., configured to be seen by both eyes), and/or can provide separate display screens for each eye, which can allow for additional flexibility for varifocal adjustments and/or for correcting a refractive error associated with a user's vision. Some examples of AR systems also include optical subsystems having one or more lenses (e.g., conventional concave or convex lenses, Fresnel lenses, or adjustable liquid lenses) through which a user can view a display screen.

For example, respective displays 1635A and 1635B can be coupled to each of the lenses 1406-1 and 1406-2 of AR system 1400. Displays 1635A and 1635B may be coupled to each of lenses 1406-1 and 1406-2, which can act together or independently to present an image or series of images to a user. In some examples, AR system 1400 includes a single display 1635A or 1635B (e.g., a near-eye display) or more than two displays 1635A and 1635B. In some examples, a first set of one or more displays 1635A and 1635B can be used to present an augmented-reality environment, and a second set of one or more display devices 1635A and 1635B can be used to present a virtual-reality environment. In some examples, one or more waveguides are used in conjunction with presenting artificial-reality content to the user of AR system 1400 (e.g., as a means of delivering light from one or more displays 1635A and 1635B to the user's eyes). In some examples, one or more waveguides are fully or partially integrated into the eyewear device 1402. Additionally, or alternatively to display screens, some artificial-reality systems include one or more projection systems. For example, display devices in AR system 1400 and/or VR system 1510 can include micro-LED projectors that project light (e.g., using a waveguide) into display devices, such as clear combiner lenses that allow ambient light to pass through. The display devices can refract the projected light toward a user's pupil and can enable a user to simultaneously view both artificial-reality content and the real world. Artificial-reality systems can also be configured with any other suitable type or form of image projection system. In some examples, one or more waveguides are provided additionally or alternatively to the one or more display(s) 1635A and 1635B.

Computing system 1620 and/or optional housing 1690 of AR system 1400 or VR system 1510 can include some or all of the components of a power system 1642A and 1642B. Power systems 1642A and 1642B can include one or more charger inputs 1643, one or more PMICs 1644, and/or one or more batteries 1645A and 1644B.

Memory 1650A and 1650B may include instructions and data, some or all of which may be stored as non-transitory computer-readable storage media within the memories 1650A and 1650B. For example, memory 1650A and 1650B can include one or more operating systems 1651, one or more applications 1652, one or more communication interface applications 1653A and 1653B, one or more graphics applications 1654A and 1654B, one or more AR processing applications 1655A and 1655B, and/or any other types of data defined above or described with respect to any other examples discussed herein.

Memory 1650A and 1650B also include data 1660A and 1660B, which can be used in conjunction with one or more of the applications discussed above. Data 1660A and 1660B can include profile data 1661, sensor data 1662A and 1662B, media content data 1663A, AR application data 1664A and 1664B, and/or any other types of data defined above or described with respect to any other examples discussed herein.

In some examples, controller 1646 of eyewear device 1402 may process information generated by sensors 1623A and/or 1623B on eyewear device 1402 and/or another electronic device within AR system 1400. For example, controller 1646 can process information from acoustic sensors 1425-1 and 1425-2. For each detected sound, controller 1646 can perform a direction of arrival (DOA) estimation to estimate a direction from which the detected sound arrived at eyewear device 1402 of AR system 1400. As one or more of acoustic sensors 1625 (e.g., the acoustic sensors 1425-1, 1425-2) detects sounds, controller 1646 can populate an audio data set with the information (e.g., represented in FIG. 16 as sensor data 1662A and 1662B).

In some examples, a physical electronic connector can convey information between eyewear device 1402 and another electronic device and/or between one or more processors 1448, 1648A, 1648B of AR system 1400 or VR system 1510 and controller 1646. The information can be in the form of optical data, electrical data, wireless data, or any other transmittable data form. Moving the processing of information generated by eyewear device 1402 to an intermediary processing device can reduce weight and heat in the eyewear device, making it more comfortable and safer for a user. In some examples, an optional wearable accessory device (e.g., an electronic neckband) is coupled to eyewear device 1402 via one or more connectors. The connectors can be wired or wireless connectors and can include electrical and/or non-electrical (e.g., structural) components. In some examples, eyewear device 1402 and the wearable accessory device can operate independently without any wired or wireless connection between them.

In some situations, pairing external devices, such as an intermediary processing device (e.g., HIPD 806, 906, 1006) with eyewear device 1402 (e.g., as part of AR system 1400) enables eyewear device 1402 to achieve a similar form factor of a pair of glasses while still providing sufficient battery and computation power for expanded capabilities. Some, or all, of the battery power, computational resources, and/or additional features of AR system 1400 can be provided by a paired device or shared between a paired device and eyewear device 1402, thus reducing the weight, heat profile, and form factor of eyewear device 1402 overall while allowing eyewear device 1402 to retain its desired functionality. For example, the wearable accessory device can allow components that would otherwise be included on eyewear device 1402 to be included in the wearable accessory device and/or intermediary processing device, thereby shifting a weight load from the user's head and neck to one or more other portions of the user's body. In some examples, the intermediary processing device has a larger surface area over which to diffuse and disperse heat to the ambient environment. Thus, the intermediary processing device can allow for greater battery and computation capacity than might otherwise have been possible on eyewear device 1402 standing alone. Because weight carried in the wearable accessory device can be less invasive to a user than weight carried in the eyewear device 1402, a user may tolerate wearing a lighter eyewear device and carrying or wearing the paired device for greater lengths of time than the user would tolerate wearing a heavier eyewear device standing alone, thereby enabling an artificial-reality environment to be incorporated more fully into a user's day-to-day activities.

AR systems can include various types of computer vision components and subsystems. For example, AR system 1400 and/or VR system 1510 can include one or more optical sensors such as two-dimensional (2D) or three-dimensional (3D) cameras, time-of-flight depth sensors, structured light transmitters and detectors, single-beam or sweeping laser rangefinders, 3D LiDAR sensors, and/or any other suitable type or form of optical sensor. An AR system can process data from one or more of these sensors to identify a location of a user and/or aspects of the use's real-world physical surroundings, including the locations of real-world objects within the real-world physical surroundings. In some examples, the methods described herein are used to map the real world, to provide a user with context about real-world surroundings, and/or to generate digital twins (e.g., interactable virtual objects), among a variety of other functions. For example, FIGS. 15A and 15B show VR system 1510 having cameras 1539A to 1539D, which can be used to provide depth information for creating a voxel field and a two-dimensional mesh to provide object information to the user to avoid collisions.

In some examples, AR system 1400 and/or VR system 1510 can include haptic (tactile) feedback systems, which may be incorporated into headwear, gloves, body suits, handheld controllers, environmental devices (e.g., chairs or floormats), and/or any other type of device or system, such as the wearable devices discussed herein. The haptic feedback systems may provide various types of cutaneous feedback, including vibration, force, traction, shear, texture, and/or temperature. The haptic feedback systems may also provide various types of kinesthetic feedback, such as motion and compliance. The haptic feedback may be implemented using motors, piezoelectric actuators, fluidic systems, and/or a variety of other types of feedback mechanisms. The haptic feedback systems may be implemented independently of other artificial-reality devices, within other artificial-reality devices, and/or in conjunction with other artificial-reality devices.

In some examples of an artificial reality system, such as AR system 1400 and/or VR system 1510, ambient light (e.g., a live feed of the surrounding environment that a user would normally see) can be passed through a display element of a respective head-wearable device presenting aspects of the AR system. In some examples, ambient light can be passed through a portion less that is less than all of an AR environment presented within a user's field of view (e.g., a portion of the AR environment co-located with a physical object in the user's real-world environment that is within a designated boundary (e.g., a guardian boundary) configured to be used by the user while they are interacting with the AR environment). For example, a visual user interface element (e.g., a notification user interface element) can be presented at the head-wearable device, and an amount of ambient light (e.g., 15-50% of the ambient light) can be passed through the user interface element such that the user can distinguish at least a portion of the physical environment over which the user interface element is being displayed.

In some examples, the systems described herein may also include an eye-tracking subsystem designed to identify and track various characteristics of a user's eye(s), such as the user's gaze direction. The phrase "eye tracking" may, in some examples, refer to a process by which the position, orientation, and/or motion of an eye is measured, detected, sensed, determined, and/or monitored. The disclosed systems may measure the position, orientation, and/or motion of an eye in a variety of different ways, including through the use of various optical-based eye-tracking techniques, ultrasound-based eye-tracking techniques, etc. An eye-tracking subsystem may be configured in a number of different ways and may include a variety of different eye-tracking hardware components or other computer-vision components. For example, an eye-tracking subsystem may include a variety of different optical sensors, such as two-dimensional (2D) or 3D cameras, time-of-flight depth sensors, single-beam or sweeping laser rangefinders, 3D LiDAR sensors, and/or any other suitable type or form of optical sensor. In this example, a processing subsystem may process data from one or more of these sensors to measure, detect, determine, and/or otherwise monitor the position, orientation, and/or motion of the user's eye(s).

FIG. 17 is an illustration of an example system 1700 that incorporates an eye-tracking subsystem capable of tracking a user's eye(s). As depicted in FIG. 17, system 1700 may include a light source 1702, an optical subsystem 1704, an eye-tracking subsystem 1706, and/or a control subsystem 1708. In some examples, light source 1702 may generate light for an image (e.g., to be presented to an eye 1701 of the viewer). Light source 1702 may represent any of a variety of suitable devices. For example, light source 1702 can include a two-dimensional projector (e.g., a LCoS display), a scanning source (e.g., a scanning laser), or other device (e.g., an LCD, an LED display, an OLED display, an active-matrix OLED display (AMOLED), a transparent OLED display (TOLED), a waveguide, or some other display capable of generating light for presenting an image to the viewer). In some examples, the image may represent a virtual image, which may refer to an optical image formed from the apparent divergence of light rays from a point in space, as opposed to an image formed from the light ray's actual divergence.

In some examples, optical subsystem 1704 may receive the light generated by light source 1702 and generate, based on the received light, converging light 1720 that includes the image. In some examples, optical subsystem 1704 may include any number of lenses (e.g., Fresnel lenses, convex lenses, concave lenses), apertures, filters, mirrors, prisms, and/or other optical components, possibly in combination with actuators and/or other devices. In particular, the actuators and/or other devices may translate and/or rotate one or more of the optical components to alter one or more aspects of converging light 1720. Further, various mechanical couplings may serve to maintain the relative spacing and/or the orientation of the optical components in any suitable combination.

In one example, eye-tracking subsystem 1706 may generate tracking information indicating a gaze angle of an eye 1701 of the viewer. In this example, control subsystem 1708 may control aspects of optical subsystem 1704 (e.g., the angle of incidence of converging light 1720) based at least in part on this tracking information. Additionally, in some examples, control subsystem 1708 may store and utilize historical tracking information (e.g., a history of the tracking information over a given duration, such as the previous second or fraction thereof) to anticipate the gaze angle of eye 1701 (e.g., an angle between the visual axis and the anatomical axis of eye 1701). In some examples, eye-tracking subsystem 1706 may detect radiation emanating from some portion of eye 1701 (e.g., the cornea, the iris, the pupil, or the like) to determine the current gaze angle of eye 1701. In other examples, eye-tracking subsystem 1706 may employ a wavefront sensor to track the current location of the pupil.

Any number of techniques can be used to track eye 1701. Some techniques may involve illuminating eye 1701 with infrared light and measuring reflections with at least one optical sensor that is tuned to be sensitive to the infrared light. Information about how the infrared light is reflected from eye 1701 may be analyzed to determine the position(s), orientation(s), and/or motion(s) of one or more eye feature(s), such as the cornea, pupil, iris, and/or retinal blood vessels.

In some examples, the radiation captured by a sensor of eye-tracking subsystem 1706 may be digitized (i.e., converted to an electronic signal). Further, the sensor may transmit a digital representation of this electronic signal to one or more processors (for example, processors associated with a device including eye-tracking subsystem 1706). Eye-tracking subsystem 1706 may include any of a variety of sensors in a variety of different configurations. For example, eye-tracking subsystem 1706 may include an infrared detector that reacts to infrared radiation. The infrared detector may be a thermal detector, a photonic detector, and/or any other suitable type of detector. Thermal detectors may include detectors that react to thermal effects of the incident infrared radiation.

In some examples, one or more processors may process the digital representation generated by the sensor(s) of eye-tracking subsystem 1706 to track the movement of eye 1701. In another example, these processors may track the movements of eye 1701 by executing algorithms represented by computer-executable instructions stored on non-transitory memory. In some examples, on-chip logic (e.g., an application-specific integrated circuit or ASIC) may be used to perform at least portions of such algorithms. As noted, eye-tracking subsystem 1706 may be programmed to use an output of the sensor(s) to track movement of eye 1701. In some examples, eye-tracking subsystem 1706 may analyze the digital representation generated by the sensors to extract eye rotation information from changes in reflections. In one example, eye-tracking subsystem 1706 may use corneal reflections or glints (also known as Purkinje images) and/or the center of the eye's pupil 1722 as features to track over time.

In some examples, eye-tracking subsystem 1706 may use the center of the eye's pupil 1722 and infrared or near-infrared, non-collimated light to create corneal reflections. In these examples, eye-tracking subsystem 1706 may use the vector between the center of the eye's pupil 1722 and the corneal reflections to compute the gaze direction of eye 1701. In some examples, the disclosed systems may perform a calibration procedure for an individual (using, e.g., supervised or unsupervised techniques) before tracking the user's eyes. For example, the calibration procedure may include directing users to look at one or more points displayed on a display while the eye-tracking system records the values that correspond to each gaze position associated with each point.

In some examples, eye-tracking subsystem 1706 may use two types of infrared and/or near-infrared (also known as active light) eye-tracking techniques: bright-pupil and dark-pupil eye tracking, which may be differentiated based on the location of an illumination source with respect to the optical elements used. If the illumination is coaxial with the optical path, then eye 1701 may act as a retroreflector as the light reflects off the retina, thereby creating a bright pupil effect similar to a red-eye effect in photography. If the illumination source is offset from the optical path, then the eye's pupil 1722 may appear dark because the retroreflection from the retina is directed away from the sensor. In some examples, bright-pupil tracking may create greater iris/pupil contrast, allowing more robust eye tracking with iris pigmentation, and may feature reduced interference (e.g., interference caused by eyelashes and other obscuring features). Bright-pupil tracking may also allow tracking in lighting conditions ranging from total darkness to a very bright environment.

In some examples, control subsystem 1708 may control light source 1702 and/or optical subsystem 1704 to reduce optical aberrations (e.g., chromatic aberrations and/or monochromatic aberrations) of the image that may be caused by or influenced by eye 1701. In some examples, as mentioned above, control subsystem 1708 may use the tracking information from eye-tracking subsystem 1706 to perform such control. For example, in controlling light source 1702, control subsystem 1708 may alter the light generated by light source 1702 (e.g., by way of image rendering) to modify (e.g., pre-distort) the image so that the aberration of the image caused by eye 1701 is reduced.

The disclosed systems may track both the position and relative size of the pupil (since, e.g., the pupil dilates and/or contracts). In some examples, the eye-tracking devices and components (e.g., sensors and/or sources) used for detecting and/or tracking the pupil may be different (or calibrated differently) for different types of eyes. For example, the frequency range of the sensors may be different (or separately calibrated) for eyes of different colors and/or different pupil types, sizes, and/or the like. As such, the various eye-tracking components (e.g., infrared sources and/or sensors) described herein may need to be calibrated for each individual user and/or eye.

The disclosed systems may track both eyes with and without ophthalmic correction, such as that provided by contact lenses worn by the user. In some examples, ophthalmic correction elements (e.g., adjustable lenses) may be directly incorporated into the artificial reality systems described herein. In some examples, the color of the user's eye may necessitate modification of a corresponding eye-tracking algorithm. For example, eye-tracking algorithms may need to be modified based at least in part on the differing color contrast between a brown eye and, for example, a blue eye.

FIG. 18 is a more detailed illustration of various aspects of the eye-tracking subsystem illustrated in FIG. 17. As shown in this figure, an eye-tracking subsystem 1800 may include at least one source 1804 and at least one sensor 1806. Source 1804 generally represents any type or form of element capable of emitting radiation. In one example, source 1804 may generate visible, infrared, and/or near-infrared radiation. In some examples, source 1804 may radiate non-collimated infrared and/or near-infrared portions of the electromagnetic spectrum towards an eye 1802 of a user. Source 1804 may utilize a variety of sampling rates and speeds. For example, the disclosed systems may use sources with higher sampling rates in order to capture fixational eye movements of a user's eye 1802 and/or to correctly measure saccade dynamics of the user's eye 1802. As noted above, any type or form of eye-tracking technique may be used to track the user's eye 1802, including optical-based eye-tracking techniques, ultrasound-based eye-tracking techniques, etc.

Sensor 1806 generally represents any type or form of element capable of detecting radiation, such as radiation reflected off the user's eye 1802. Examples of sensor 1806 include, without limitation, a charge coupled device (CCD), a photodiode array, a complementary metal-oxide-semiconductor (CMOS) based sensor device, and/or the like. In one example, sensor 1806 may represent a sensor having predetermined parameters, including, but not limited to, a dynamic resolution range, linearity, and/or other characteristic selected and/or designed specifically for eye tracking.

As detailed above, eye-tracking subsystem 1800 may generate one or more glints. As detailed above, a glint 1803 may represent reflections of radiation (e.g., infrared radiation from an infrared source, such as source 1804) from the structure of the user's eye. In various examples, glint 1803 and/or the user's pupil may be tracked using an eye-tracking algorithm executed by a processor (either within or external to an artificial reality device). For example, an artificial reality device may include a processor and/or a memory device in order to perform eye tracking locally and/or a transceiver to send and receive the data necessary to perform eye tracking on an external device (e.g., a mobile phone, cloud server, or other computing device).

FIG. 18 shows an example image 1805 captured by an eye-tracking subsystem, such as eye-tracking subsystem 1800. In this example, image 1805 may include both the user's pupil 1808 and a glint 1810 near the same. In some examples, pupil 1808 and/or glint 1810 may be identified using an artificial-intelligence-based algorithm, such as a computer-vision-based algorithm. In one example, image 1805 may represent a single frame in a series of frames that may be analyzed continuously in order to track the eye 1802 of the user. Further, pupil 1808 and/or glint 1810 may be tracked over a period of time to determine a user's gaze.

In one example, eye-tracking subsystem 1800 may be configured to identify and measure the inter-pupillary distance (IPD) of a user. In some examples, eye-tracking subsystem 1800 may measure and/or calculate the IPD of the user while the user is wearing the artificial reality system. In these examples, eye-tracking subsystem 1800 may detect the positions of a user's eyes and may use this information to calculate the user's IPD.

As noted, the eye-tracking systems or subsystems disclosed herein may track a user's eye position and/or eye movement in a variety of ways. In one example, one or more light sources and/or optical sensors may capture an image of the user's eyes. The eye-tracking subsystem may then use the captured information to determine the user's inter-pupillary distance, interocular distance, and/or a 3D position of each eye (e.g., for distortion adjustment purposes), including a magnitude of torsion and rotation (i.e., roll, pitch, and yaw) and/or gaze directions for each eye. In one example, infrared light may be emitted by the eye-tracking subsystem and reflected from each eye. The reflected light may be received or detected by an optical sensor and analyzed to extract eye rotation data from changes in the infrared light reflected by each eye.

The eye-tracking subsystem may use any of a variety of different methods to track the eyes of a user. For example, a light source (e.g., infrared light-emitting diodes) may emit a dot pattern onto each eye of the user. The eye-tracking subsystem may then detect (e.g., via an optical sensor coupled to the artificial reality system) and analyze a reflection of the dot pattern from each eye of the user to identify a location of each pupil of the user. Accordingly, the eye-tracking subsystem may track up to six degrees of freedom of each eye (i.e., 3D position, roll, pitch, and yaw) and at least a subset of the tracked quantities may be combined from two eyes of a user to estimate a gaze point (i.e., a 3D location or position in a virtual scene where the user is looking) and/or an IPD.

In some cases, the distance between a user's pupil and a display may change as the user's eye moves to look in different directions. The varying distance between a pupil and a display as viewing direction changes may be referred to as "pupil swim" and may contribute to distortion perceived by the user as a result of light focusing in different locations as the distance between the pupil and the display changes. Accordingly, measuring distortion at different eye positions and pupil distances relative to displays and generating distortion corrections for different positions and distances may allow mitigation of distortion caused by pupil swim by tracking the 3D position of a user's eyes and applying a distortion correction corresponding to the 3D position of each of the user's eyes at a given point in time. Thus, knowing the 3D position of each of a user's eyes may allow for the mitigation of distortion caused by changes in the distance between the pupil of the eye and the display by applying a distortion correction for each 3D eye position. Furthermore, as noted above, knowing the position of each of the user's eyes may also enable the eye-tracking subsystem to make automated adjustments for a user's IPD.

In some examples, a display subsystem may include a variety of additional subsystems that may work in conjunction with the eye-tracking subsystems described herein. For example, a display subsystem may include a varifocal subsystem, a scene-rendering module, and/or a vergence-processing module. The varifocal subsystem may cause left and right display elements to vary the focal distance of the display device. In one example, the varifocal subsystem may physically change the distance between a display and the optics through which it is viewed by moving the display, the optics, or both. Additionally, moving or translating two lenses relative to each other may also be used to change the focal distance of the display. Thus, the varifocal subsystem may include actuators or motors that move displays and/or optics to change the distance between them. This varifocal subsystem may be separate from or integrated into the display subsystem. The varifocal subsystem may also be integrated into or separate from its actuation subsystem and/or the eye-tracking subsystems described herein.

In one example, the display subsystem may include a vergence-processing module configured to determine a vergence depth of a user's gaze based on a gaze point and/or an estimated intersection of the gaze lines determined by the eye-tracking subsystem. Vergence may refer to the simultaneous movement or rotation of both eyes in opposite directions to maintain single binocular vision, which may be naturally and automatically performed by the human eye. Thus, a location where a user's eyes are verged is where the user is looking and is also typically the location where the user's eyes are focused. For example, the vergence-processing module may triangulate gaze lines to estimate a distance or depth from the user associated with intersection of the gaze lines. The depth associated with intersection of the gaze lines may then be used as an approximation for the accommodation distance, which may identify a distance from the user where the user's eyes are directed. Thus, the vergence distance may allow for the determination of a location where the user's eyes should be focused and a depth from the user's eyes at which the eyes are focused, thereby providing information (such as an object or plane of focus) for rendering adjustments to the virtual scene.

The vergence-processing module may coordinate with the eye-tracking subsystems described herein to make adjustments to the display subsystem to account for a user's vergence depth. When the user is focused on something at a distance, the user's pupils may be slightly farther apart than when the user is focused on something close. The eye-tracking subsystem may obtain information about the user's vergence or focus depth and may adjust the display subsystem to be closer together when the user's eyes focus or verge on something close and to be farther apart when the user's eyes focus or verge on something at a distance.

The eye-tracking information generated by the above-described eye-tracking subsystems may also be used, for example, to modify various aspect of how different computer-generated images are presented. For example, a display subsystem may be configured to modify, based on information generated by an eye-tracking subsystem, at least one aspect of how the computer-generated images are presented. For instance, the computer-generated images may be modified based on the user's eye movement, such that if a user is looking up, the computer-generated images may be moved upward on the screen. Similarly, if the user is looking to the side or down, the computer-generated images may be moved to the side or downward on the screen. If the user's eyes are closed, the computer-generated images may be paused or removed from the display and resumed once the user's eyes are back open.

The above-described eye-tracking subsystems can be incorporated into one or more of the various artificial reality systems described herein in a variety of ways. For example, one or more of the various components of system 1700 and/or eye-tracking subsystem 1800 may be incorporated into any of the augmented-reality systems in and/or virtual-reality systems described herein in to enable these systems to perform various eye-tracking tasks (including one or more of the eye-tracking operations described herein).

As detailed above, the computing devices and systems described and/or illustrated herein broadly represent any type or form of computing device or system capable of executing computer-readable instructions, such as those contained within the modules described herein. In their most basic configuration, these computing device(s) may each include at least one memory device and at least one physical processor.

In some examples, the term "memory device" generally refers to any type or form of volatile or non-volatile storage device or medium capable of storing data and/or computer-readable instructions. In one example, a memory device may store, load, and/or maintain one or more of the modules described herein. Examples of memory devices include, without limitation, Random Access Memory (RAM), Read Only Memory (ROM), flash memory, Hard Disk Drives (HDDs), Solid-State Drives (SSDs), optical disk drives, caches, variations or combinations of one or more of the same, or any other suitable storage memory.

In some examples, the term "physical processor" generally refers to any type or form of hardware-implemented processing unit capable of interpreting and/or executing computer-readable instructions. In one example, a physical processor may access and/or modify one or more modules stored in the above-described memory device. Examples of physical processors include, without limitation, microprocessors, microcontrollers, Central Processing Units (CPUs), Field-Programmable Gate Arrays (FPGAs) that implement softcore processors, Application-Specific Integrated Circuits (ASICs), portions of one or more of the same, variations or combinations of one or more of the same, or any other suitable physical processor.

Although illustrated as separate elements, the modules described and/or illustrated herein may represent portions of a single module or application. In addition, in certain examples one or more of these modules may represent one or more software applications or programs that, when executed by a computing device, may cause the computing device to perform one or more tasks. For example, one or more of the modules described and/or illustrated herein may represent modules stored and configured to run on one or more of the computing devices or systems described and/or illustrated herein. One or more of these modules may also represent all or portions of one or more special-purpose computers configured to perform one or more tasks.

In addition, one or more of the modules described herein may transform data, physical devices, and/or representations of physical devices from one form to another. Additionally or alternatively, one or more of the modules recited herein may transform a processor, volatile memory, non-volatile memory, and/or any other portion of a physical computing device from one form to another by executing on the computing device, storing data on the computing device, and/or otherwise interacting with the computing device.

In some examples, the term "computer-readable medium" generally refers to any form of device, carrier, or medium capable of storing or carrying computer-readable instructions. Examples of computer-readable media include, without limitation, transmission-type media, such as carrier waves, and non-transitory-type media, such as magnetic-storage media (e.g., hard disk drives, tape drives, and floppy disks), optical-storage media (e.g., Compact Disks (CDs), Digital Video Disks (DVDs), and BLU-RAY disks), electronic-storage media (e.g., solid-state drives and flash media), and other distribution systems.

The process parameters and sequence of the steps described and/or illustrated herein are given by way of example only and can be varied as desired. For example, while the steps illustrated and/or described herein may be shown or discussed in a particular order, these steps do not necessarily need to be performed in the order illustrated or discussed. The various exemplary methods described and/or illustrated herein may also omit one or more of the steps described or illustrated herein or include additional steps in addition to those disclosed.

The preceding description has been provided to enable others skilled in the art to best utilize various aspects of the examples disclosed herein. This exemplary description is not intended to be exhaustive or to be limited to any precise form disclosed. Many modifications and variations are possible without departing from the scope of the present disclosure. The examples disclosed herein should be considered in all respects illustrative and not restrictive. Reference should be made to the appended claims and their equivalents in determining the scope of the present disclosure.

Unless otherwise noted, the terms "connected to" and "coupled to" (and their derivatives), as used in the specification and claims, are to be construed as permitting both direct and indirect (i.e., via other elements or components) connection. In addition, the terms "a" or "an," as used in the specification and claims, are to be construed as meaning "at least one of." Finally, for ease of use, the terms "including" and "having" (and their derivatives), as used in the specification and claims, are interchangeable with and have the same meaning as the word "comprising."

## Claims

1. A system comprising:
a plurality of addressable display elements comprising a plurality of subsets;
a shift register comprising a first plurality of flip flops each coupled to a first clock input;
a second plurality of flip flops each configured to receive an output from a respective one of the first plurality of flip flops, each of the second plurality of flip flops being coupled to a second clock input, and each of the second plurality of flip flops configured to output a gate signal to a respective subset of the plurality of subsets of the plurality of addressable display elements; and
a controller configured to control, by controlling a frequency of the first clock input, which one or more subsets of the plurality of addressable display elements simultaneously receive the gate signal from flip flops of the second plurality of flip flops.

2. The system of claim 1, wherein the plurality of addressable display elements are arranged in a grid, and wherein the plurality of subsets of the plurality of addressable display elements are rows of addressable display elements in the grid.

3. The system of claim 1 or 2, wherein the plurality of subsets of the plurality of addressable display elements is a plurality of first subsets of the plurality of addressable display elements, wherein the controller is further configured to send a display signal to selected ones of a plurality of second subsets of the plurality of addressable display elements, and wherein each of the plurality of second subsets intersects each of the plurality of first subsets.

4. The system of claim 3, wherein the plurality of addressable display elements are arranged in a grid, and wherein the plurality of first subsets are a plurality of rows of addressable display elements in the grid and wherein the plurality of second subsets are a plurality of columns of the addressable display elements in the grid;
preferably wherein the display signal controls a brightness and/or color of light to be emitted by display elements in the plurality of second subsets of the plurality of addressable display elements that also receive the gate signal from one or more flip flops of the second plurality of flip flops.

5. The system of any preceding claim, wherein the frequency of the first clock input is an integer multiple of a frequency of the second clock input.

6. The system of any preceding claim, wherein at least some of the first plurality of flip flops in the shift register are configured to receive an input from the output of another of the first plurality of flip flops.

7. The system of any preceding claim, wherein a first flip flop in the first plurality of flip flops in the shift register is configured to receive an input pattern signal, and wherein each of the first plurality of flip flops other than the first flip flop is configured to receive an input from the output of another of the first plurality of flip flops.

8. The system of any preceding claim, wherein the controller is configured to adjust the frequency of the first clock input while the plurality of addressable display elements are operated to produce an image frame by successively providing the gate signal to each of the plurality of subsets of the plurality of addressable display elements.

9. The system of any preceding claim, wherein the controller, the shift register and the second plurality of flip flops are implemented as an integrated circuit.

10. A method comprising:
providing an input pattern to a shift register comprising a first plurality of flip flops each operating according to a first clock frequency;
producing first gate signals from a first subset of a second plurality of flip flops each configured to receive an output from a respective one of the first plurality of flip flops;
directing each of the first gate signals to respective rows of display elements in a grid of display elements;
increasing or decreasing the first clock frequency; and
producing second gate signals from a second subset of the second plurality of flip flops, wherein a number of the second plurality of flip flops in the first subset is different from a number of the second plurality of flip flops in the second subset.

11. The method of claim 10, further comprising directing each of the second gate signals to respective rows of the display elements in the grid of display elements.

12. The method of claim 10 or 11, comprising:
producing a respective first gate signal from each of two of the second plurality of flip flops;
decreasing the first clock frequency by a factor of two; and
producing a single second gate signal from one of the second plurality of flip flops.

13. The method of any of claims 10 to 12, further comprising directing a display signal to one or more columns of display elements in the grid of display elements, thereby simultaneously directing both the display signal and one or more of the first gate signals to one or more display elements;
preferably comprising directing the display signal to two columns of display elements in the grid of display elements and simultaneously directing a respective gate signal of the first gate signals to two rows of display elements, thereby simultaneously directing both the display signal and one of the first gate signals to four display elements;
further preferably wherein:
increasing or decreasing the first clock frequency comprises decreasing the first clock frequency by a factor of two,
the display signal is a first display signal, and
the method comprises, subsequent to simultaneously directing both the first display signal and one of the first gate signals to four display elements, directing a second display signal to a single column of display elements in the grid of display elements and simultaneously directing a single second gate signal to a single row of display elements.

14. The method of any of claims 10 to 13, comprising increasing or decreasing the first clock frequency while producing an image frame from the grid of display elements by successively providing gate signals of the first gate signals to each of the rows of display elements.

15. The method of any of claims 10 to 14, wherein the second plurality of flip flops each operate according to a second clock frequency;
preferably wherein the first clock frequency is an integer multiple of the second clock frequency.
